# EUROPEAN PATENT APPLICATION

(11) **EP 4 503 430 A1**
(43) Date of publication of application: **05.02.2025**
(21) Application number: 23775023.7
(22) Date of filing: 23.03.2023
(51) Int. Cl.: H02S 20/10, H02S 20/20, H02S 20/23, E04D 1/30, E04D 3/40, E04D 13/18, H01L 31/048, H02S 30/10, H10K 30/40, H10K 39/10

(54) **INSTALLATION STRUCTURE FOR PHOTOVOLTAIC POWER GENERATION SHEET**

(30) Priority: 24.03.2022 JP 2022048274; 01.12.2022 JP 2022193167
(71) Applicant: SEKISUI CHEMICAL CO., LTD., Osaka-shi Osaka 530-8565 (JP)
(72) Inventor: INAMORI, Daiki, Osaka-shi, Osaka 530-8565 (JP); YOKOTA, Ibuki, Osaka-shi, Osaka 530-8565 (JP); UNO, Tomohito, Osaka-shi, Osaka 530-8565 (JP); HAYAKAWA, Akinobu, Osaka-shi, Osaka 530-8565 (JP); ARAI, Nozomi, Osaka-shi, Osaka 530-8565 (JP); FUJIMORI, Yuji, Osaka-shi, Osaka 530-8565 (JP)
(74) Representative: Ter Meer Steinmeister & Partner
(86) International application number: PCT/JP2023/011513
(87) International publication number: WO 2023/182429

(57) **Abstract**

Provided is an installation structure for a photovoltaic power generation sheet that can suppress adhesion of dirt contained in moisture dropped on a surface of the photovoltaic power generation sheet to the surface of the photovoltaic power generation sheet. The installation structure 1 of the photovoltaic power generation sheet according to the present invention includes an installation surface 2 which is a ground surface or a floor surface of a building, and a photovoltaic power generation sheet 4 provided on an upper side of the installation surface 2. The surface 6 of the photovoltaic power generation sheet 4 is inclined at an angle of 1.5° or more with respect to the horizontal plane, and the critical surface tension γc of the surface 6 of the photovoltaic power generation sheet 4 is 20 or more and 45 or less.

## Description

### Technical Field

The present invention relates to an installation structure for a photovoltaic power generation sheet in which a photovoltaic power generation sheet is provided on an installation surface that is a ground surface or a floor surface of a building.

### Background Art

PTL 1 discloses a solar cell panel including a photovoltaic module, a translucent support member, and a translucent surface protective layer. The solar cell panel is provided on an upper side of a hard pavement body, and the hard pavement body is made of a material used for a road surface. The photovoltaic module is a member that converts light into electric energy, and is fixed to a hard pavement body. The translucent support member is fixed to the light incident surface of the photovoltaic module. The surface protective layer has a structure in which fine particles are mixed in the base material resin, and is formed on a surface side of the translucent support member.

### Citation List

### Patent Literature

PTL 1: JP2021-101478A

### Summary of Invention

### Technical Problem

Incidentally, in a case where the photovoltaic power generation sheet is provided on an upper side of an installation surface such as a ground surface (a surface of a pavement body or the like of a road) or a floor surface of a building (a surface of a roof or the like), it is desirable to remove moisture dropped on the surface of the photovoltaic power generation sheet in order to maintain power generation efficiency of the photovoltaic power generation sheet. In this regard, PTL 1 discloses that slip is prevented by fine particles exposed on the surface of the surface protective layer, but does not disclose removing moisture such as rainwater adhered to the surface protective layer. In a case where the moisture continues to adhere to the surface protective layer, evaporation of the moisture causes dirt contained in the moisture to adhere to the surface protective layer, and the dirt blocks sunlight, causing power generation efficiency to decrease. In addition, in the surface protective layer to which fine particles adhere, the dirt tends to adhere with the particles as a starting point, and thus aesthetic feeling tends to decrease.

The present invention has been made in view of the above problems, and an object of the present invention is to provide an installation structure for a photovoltaic power generation sheet in which the photovoltaic power generation sheet is provided on an upper side of an installation surface, the installation structure for the photovoltaic power generation sheet being capable of suppressing adhesion of dirt contained in moisture dropped on a surface of the photovoltaic power generation sheet to the surface of the photovoltaic power generation sheet.

### Solution to Problem

In order to achieve the above object, the present invention encompasses the subject matter according to the following items:
Item 1. An installation structure for a photovoltaic power generation sheet including:
   an installation surface; and
   a photovoltaic power generation sheet provided on an upper side of the installation surface,
   a surface of the photovoltaic power generation sheet including a surface inclined at an angle of 1.5° or more with respect to a horizontal plane, and a critical surface tension γc of a surface of the photovoltaic power generation sheet being 20 or more and 45 or less.
Item 2. The installation structure according to the item 1, wherein
   a groove is formed on a surface of the photovoltaic power generation sheet, and
   the groove extends in a direction where a surface of the photovoltaic power generation sheet is inclined.
Item 3. The installation structure according to item 1 or 2, wherein the photovoltaic power generation sheet includes a plurality of power generation cells containing a perovskite compound.
Item 4. The installation structure according to any one of items 1 to 3, wherein in a cross section of the photovoltaic power generation sheet perpendicular to a direction where a surface of the photovoltaic power generation sheet is inclined, a surface of the photovoltaic power generation sheet has an arc shape recessed downward.
Item 5. The installation structure according to any one of items 1 to 4, further including
   a support member installed on the installation surface, wherein
   the support member has a surface inclined at an angle of 1.5° or more with respect to a horizontal plane, and the photovoltaic power generation sheet is installed on a surface of the support member.
Item 6. The installation structure according to any one of items 1 to 4, wherein
   the installation surface is inclined at an angle of 1.5° or more with respect to a horizontal plane, and
   the photovoltaic power generation sheet is installed on the installation surface.

### Advantageous Effects of Invention

According to the installation structure according to the present invention, it is possible to suppress adhesion of dirt contained in moisture such as rainwater dropped on the surface of the photovoltaic power generation sheet to the surface of the photovoltaic power generation sheet.

### Brief Description of Drawings

Fig. 1(A) is a schematic plan view illustrating an installation structure for a photovoltaic power generation sheet according to a first embodiment of the present invention, and Fig. 1(B) is a schematic cross-sectional view taken along line a-a in Fig. 1(A).
Fig. 2(A) is a schematic cross-sectional view taken along line b-b in Fig. 1(A) . Fig. 2(B) is an enlarged view of a part c in Fig. 2(A). Fig. 2(C) is a cross-sectional view illustrating a state in which the power generator is cut along the d-d line of Fig. 2(A).
Fig. 3(A) is a schematic plan view illustrating an installation structure for a photovoltaic power generation sheet according to a second embodiment of the present invention, and Fig. 3(B) is a schematic cross-sectional view taken along line a-a in Fig. 3(A).
Fig. 4 is a schematic cross-sectional view taken along line b-b in Fig. 3(A).
Fig. 5(A) is a schematic plan view illustrating an installation structure for a photovoltaic power generation sheet according to a third embodiment of the present invention, and Fig. 5(B) is a schematic cross-sectional view taken along line a-a in Fig. 5(A).
Fig. 6 is a schematic cross-sectional view taken along line b-b in Fig. 5(A).
Fig. 7(A) is a schematic plan view illustrating an installation structure for a photovoltaic power generation sheet according to a modification of the first embodiment of the present invention, and Fig. 7(B) is a schematic cross-sectional view taken along line a-a in Fig. 7(A) .
Fig. 8(A) is a schematic plan view illustrating an installation structure for a photovoltaic power generation sheet according to a modification of the second embodiment of the present invention, and Fig. 8(B) is a schematic cross-sectional view taken along line a-a in Fig. 8(A) .
Fig. 9(A) is a schematic plan view illustrating an installation structure for a photovoltaic power generation sheet according to a modification of the third embodiment of the present invention, and Fig. 9(B) is a schematic cross-sectional view taken along line a-a in Fig. 9(A).
Fig. 10 is a schematic plan view illustrating an installation structure for a photovoltaic power generation sheet according to a modification of the present invention.
Fig. 11 is a schematic cross-sectional view taken along line a-a in Fig. 10.
Figs. 12(A) to 12(G) are cross-sectional views of a fixture.
Figs. 13(A) to 13(F) are views illustrating a fixture, upper views of Figs. 13(A) to 13(F) are plan views of the fixture, and lower views of Figs. 13(A) to 13(F) are a cross-sectional views of the fixture.
Fig. 14(A) is a schematic plan view illustrating an installation structure for a photovoltaic power generation sheet according to a modification of the present invention, and Fig. 14(B) is a schematic cross-sectional view illustrating a state in which the installation structure is cut along line a-a of Fig. 14 (A).
Figs. 15(A) and 15(B) are schematic cross-sectional views of an installation structure for a photovoltaic power generation sheet according to a modification of the present invention.
Fig. 16(A) is a schematic plan view illustrating an installation structure for a photovoltaic power generation sheet according to a modification of the present invention, and Fig. 16(B) is a schematic cross-sectional view illustrating a state in which the installation structure is cut along line a-a of Fig. 16(A).
Fig. 17(A) is a schematic plan view illustrating an installation structure for a photovoltaic power generation sheet according to a modification of the present invention, and Fig. 17(B) is a schematic cross-sectional view illustrating a state in which the installation structure is cut along line a-a of Fig. 17 (A).
Fig. 18(A) is a schematic plan view illustrating an installation structure for a photovoltaic power generation sheet according to a modification of the present invention, and Fig. 18(B) is a schematic cross-sectional view illustrating a state in which the installation structure is cut along line a-a of Fig. 18(A) .
Fig. 19 is an exploded perspective view of an installation structure for a photovoltaic power generation sheet according to a modification of the present invention.
Fig. 20 is a cross-sectional view of an installation structure for a photovoltaic power generation sheet according to a modification of the present invention, taken along a cross section orthogonal to a water flow direction.
Fig. 21 is a plan view of an installation structure for a photovoltaic power generation sheet according to a modification of the present invention.
Fig. 22 is a plan view of an installation structure for a photovoltaic power generation sheet according to a modification of the present invention.
Fig. 23 is a plan view of an installation structure for a photovoltaic power generation sheet according to a modification of the present invention.
Fig. 24 is a plan view of an installation structure for a photovoltaic power generation sheet according to a modification of the present invention.
Fig. 25 is an exploded perspective view of an installation structure for a photovoltaic power generation sheet according to a modification of the present invention.
Fig. 26 is a cross-sectional view of an installation structure for a photovoltaic power generation sheet according to a modification of the present invention, taken along a cross section orthogonal to a water flow direction.
Fig. 27 is a plan view of an installation structure for a photovoltaic power generation sheet according to a modification of the present invention.
Fig. 28 is a plan view of an installation structure for a photovoltaic power generation sheet according to a modification of the present invention.
Fig. 29 is a plan view of an installation structure for a photovoltaic power generation sheet according to a modification of the present invention.
Fig. 30 is a schematic view of an installation structure for a photovoltaic power generation sheet according to a modification of the present invention.
Fig. 31 is a schematic diagram of a photovoltaic power generation sheet according to a modification of the present invention, where Fig. 31(A) is a plan view, Fig. 31(B) is a rear view, Fig. 31(C) is a cross-sectional view taken along line a-a of Fig. 31(A), and Fig. 31(D) is a front view.
Fig. 32 is a schematic diagram of a photovoltaic power generation sheet according to a modification of the present invention, where Fig. 32(A) is a plan view, Fig. 32(B) is a rear view, and Fig. 32(C) is a cross-sectional view taken along line a-a of Fig. 32(A) .
Fig. 33 is a schematic diagram of a photovoltaic power generation sheet according to a modification of the present invention, where Fig. 33(A) is a plan view, Fig. 33(B) is a rear view, and Fig. 33(C) is a cross-sectional view taken along line a-a of Fig. 33(A) .
Fig. 34 is a schematic view of an installation structure for a photovoltaic power generation sheet according to a modification of the present invention.
Fig. 35 is a schematic view of an installation structure for a photovoltaic power generation sheet according to a modification of the present invention, where Fig. 35(A) is a front view and Fig. 35(B) is a plan view.
Fig. 36 is a perspective view of a state in which a photovoltaic power generation sheet is removed in an installation structure for a photovoltaic power generation sheet according to a modification of the present invention.
Fig. 37 is a longitudinal sectional view of an installation structure for a photovoltaic power generation sheet according to a modification of the present invention.
Fig. 38 is a perspective view illustrating a relationship between a fixing member and a power generator in an installation structure for a photovoltaic power generation sheet according to a modification of the present invention.

### Description of Embodiments

### First embodiment

Hereinafter, embodiments of the present invention will be described with reference to the accompanying drawings.

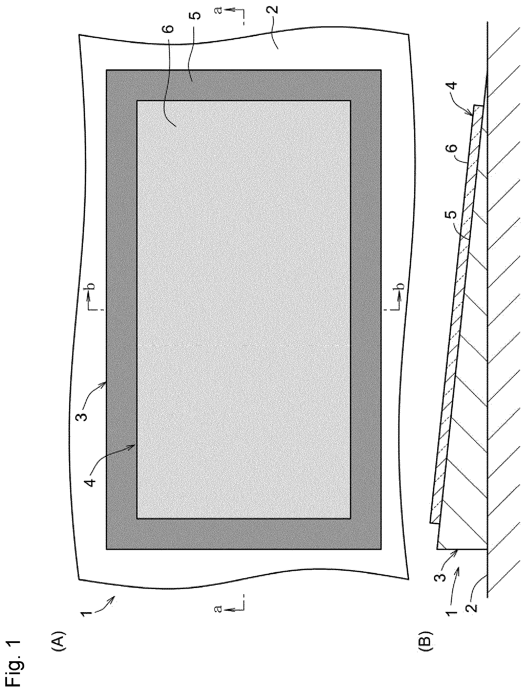

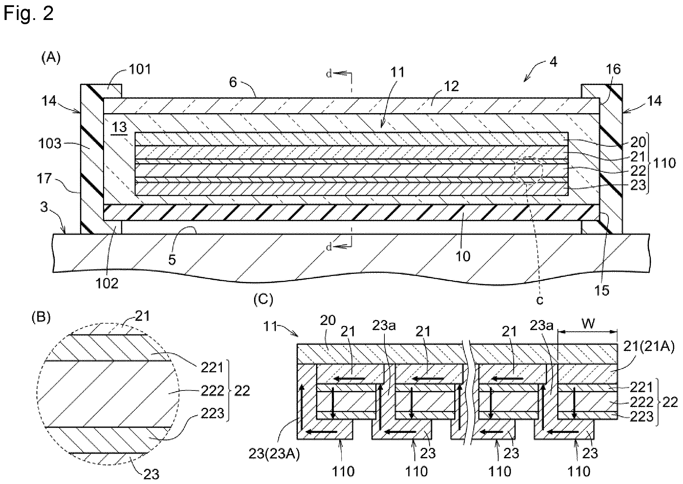

Fig. 1(A) is a schematic plan view illustrating an installation structure 1 for a photovoltaic power generation sheet 4 according to a first embodiment of the present invention, and Fig. 1(B) is a schematic cross-sectional view taken along line a-a in Fig. 1(A). Fig. 2(A) is a schematic cross-sectional view taken along line b-b in Fig. 1(A). Fig. 2(B) is an enlarged view of a part c in Fig. 2(A) . Fig. 2(C) is a cross-sectional view illustrating a state in which the power generator is cut along the d-d line of Fig. 2(A).

The installation structure 1 according to the first embodiment includes an installation surface 2, a support member 3, and a photovoltaic power generation sheet 4. The support member 3 and the photovoltaic power generation sheet 4 are provided on an upper side of the installation surface 2.

The installation surface 2 is a ground surface or a surface of a building. The ground surface includes a surface of a pavement body of a road. The surface of the building includes a surface of a roof member of the building and a surface of a building material such as a wall member (metal-based siding material, ceramic-based siding material, sandwich panel, and the like), a partition, a door member, a fence member, and a floor member. Examples of the roof member include roof members used for a folded plate roof, a slate roof, a roof deck, a shingled bar-laid roof, an upright flat laid roof, and the like. The roof may be a vertical roof or a horizontal roof.

### Support member 31

The support member 3 is installed on the installation surface 2, and has a surface 5 inclined at an angle of 1.5° or more with respect to a horizontal plane. In the illustrated example, the support member 3 is assumed to have a cross section in the form of a triangle, and the surface 5 is constituted by an inclined surface of the triangle. Here, the structure for the support member 3 is not particularly limited as long as the "support member 3 has a surface inclined at an angle of 1.5° or more with respect to a horizontal plane". Further, the support member 3 is formed of, for example, concrete, resin, metal, or the like, and the material of the support member 3 is also not particularly limited. The support member 3 is fixed to the installation surface 2 using a fixing member (not illustrated), and the fixing member is not particularly limited, and for example, a bolt, a screw, a clip, a bonder, a magnet, a pin, a nail, a weight, or the like can be used as the fixing member.

### Photovoltaic power generation sheet 4

Fig. 2(A) is a cross-sectional view of the photovoltaic power generation sheet 4. Fig. 2(B) is an enlarged view of a part c in Fig. 2 (A). The photovoltaic power generation sheet 4 has a sheet shape, and can generate power by receiving sunlight. The term "sheet shape" as used herein refers to a shape in which the thickness of the object is 10% or less with respect to the maximum length between the outer edges in plan view. When the shape in plan view is a rectangular shape, the "maximum length between the outer edges in plan view" refers to a length of a diagonal line. When the shape in plan view is a circular shape, the "maximum length between the outer edges in plan view" refers to the length of the diameter. In the present description, a film shape, a foil shape, a film shape, and the like are also included in the "sheet shape".

The photovoltaic power generation sheet 4 according to the present embodiment is formed in a substantially rectangular shape in plan view. Here, in the present invention, the shape of the photovoltaic power generation sheet 4 may be, for example, a substantially circular shape in plan view, an elliptical shape in plan view, a polygonal shape in plan view, or the like, and is not particularly limited.

The photovoltaic power generation sheet 4 has a surface 6 having a critical surface tension γc of 20 or more and 45 or less. By installing the photovoltaic power generation sheet 4 on the "surface 5 of the support member 3 inclined at an angle of 1.5° or more with respect to the horizontal plane" described above, the surface 6 of the photovoltaic power generation sheet 4 is also inclined at an angle of 1.5° or more with respect to the horizontal plane. The surface 6 of the photovoltaic power generation sheet 4 may be parallel to the surface 5 of the support member 3, and may not be parallel thereto.

The photovoltaic power generation sheet 4 is fixed to the surface 5 of the support member 3 using a fixing member (not illustrated). The fixing member is not particularly limited as long as the photovoltaic power generation sheet 4 can be fixed, and examples thereof include a bolt, a screw, a clip, a bonder, a magnet, a pin, a nail, and a weight. From the viewpoint of waterproofness, it is preferable to use a bonder, a magnet, or a weight that does not require forming a hole. In addition, it is preferable to use a bolt and a screw from the viewpoint of construction and attachment strength.

The photovoltaic power generation sheet 4 has a light receiving surface on at least one surface in the thickness direction. The light receiving surface is a surface on which sunlight is incident. As illustrated in Fig. 2, the photovoltaic power generation sheet 4 includes a back sheet 10, a power generator 11, a barrier sheet 12 including a light receiving surface, a sealant 13, and a sealing edge member 14. The power generator 11 and the sealant 13 are disposed between the back sheet 10 and the barrier sheet 12. The sealing edge member 14 seals between the outer peripheral edge 15 of the back sheet 10 and the outer peripheral edge 16 of the barrier sheet 12. The sunlight incident on the barrier sheet 12 is incident on the power generator 11 through the sealant 13.

The photovoltaic power generation sheet 4 is flexible. The term "is flexible" as used herein refers to the property of an object to flex. The flexural strength of the photovoltaic power generation sheet 4 according to the present embodiment is not particularly limited, and is preferably 10 MPa or more, more preferably 20 MPa or more, and more preferably 50 MPa or more. The flexural strength of the photovoltaic power generation sheet 4 is preferably 200 MPa or less, more preferably 150 MPa or less, and more preferably 50 MPa or less. Further, the photovoltaic power generation sheet 4 may be defined by a flexural modulus, and is preferably 100 MPa or more, and more preferably 500 MPa or more. On the other hand, the flexural modulus of the photovoltaic power generation sheet 4 is preferably 10,000 MPa or more, more preferably 5000 MPa or less. When the photovoltaic power generation sheet 4 is defined by the flexural modulus, the flexural strength may not be included in the above range. The flexural strength and flexural modulus of the photovoltaic power generation sheet 4 are measured in accordance with JIS K 7171. As described above, since the photovoltaic power generation sheet 4 is flexible, the photovoltaic power generation sheet 4 can follow the shape of the installation surface 2, and does not easily flutter due to wind or the like under the installed state.

As used herein, "photovoltaic power generation sheet 4" includes a photovoltaic power generation sheet module having a plurality of power generation cells 110, a photovoltaic power generation sheet string having a plurality of photovoltaic power generation sheet modules, and a photovoltaic power generation sheet array having a plurality of photovoltaic power generation sheet strings.

### Back sheet 10

The back sheet 10 is disposed on a side opposite to the surface 6 (light receiving surface) of the photovoltaic power generation sheet 4. The back sheet 10 constitutes a surface of the photovoltaic power generation sheet 4 facing the surface 5 of the support member 3. The back sheet 10 has barrier performance against water vapor and protection performance against external force. The back sheet 10 may be translucent, but does not necessarily need to be translucent. The term "be translucent" as used herein refers to a light transmittance of 10% or more relative to the peak wavelength of light prior to incidence.

The term "be translucent" as used herein refers to a light transmittance of 10% or more with respect to the peak wavelength of light prior to incidence.

The back sheet 10 is flexible. The modulus of longitudinal elasticity of the back sheet 10 is preferably 2400 MPa or more, and more preferably 3000 MPa or more. The modulus of longitudinal elasticity of the back sheet 10 is preferably 4200 MPa or less, more preferably 3100 MPa or less. Examples of the material of the back sheet 10 include synthetic resin such as a thermoplastic resin, a thermosetting resin, a general-purpose plastic, an engineering plastic, and a vinyl resin (for example, polyvinyl chloride). As a material of the back sheet 10, for example, natural resin, rubber, metal, carbon, pulp, or the like may be used in addition to the synthetic resin.

The thickness of the back sheet 10 is preferably 50 µm or more, and more preferably 100 µm or more. The thickness of the back sheet 10 is preferably 2000 µm or less, and more preferably 1000 µm or less.

### Power generator 11

The power generator 11 is a photoelectric conversion element using a photovoltaic effect, and includes a power generation cell 110 that generates power by receiving sunlight. The power generator 11 may be provided only one for each photovoltaic power generation sheet 4, or the power generator 11 may be sectioned in a plurality of locations. In the present embodiment, the power generator 11 includes a photoelectric conversion unit in which a plurality of power generation cells 110 are arranged in a surface direction of the photovoltaic power generation sheet 4 (for example, a longitudinal direction or a width direction of the photovoltaic power generation sheet 4). Note that the power generator 11 may be configured by one power generation cell 110.

The power generation cell 110 is a photoelectric conversion element using a photovoltaic effect, and is a minimum unit element capable of generating power. As illustrated in Fig. 2(A), the power generation cell 110 includes a translucent base member 20, a translucent conductive layer 21, a power generation layer 22, and an electrode 23. The translucent base member 20, the translucent conductive layer 21, the power generation layer 22, and the electrode 23 are stacked in this order in a direction from the barrier sheet 12 toward the back sheet 10. That is, the translucent base member 20 is disposed in a manner of facing the barrier sheet 12, and the electrode 23 is disposed in a manner of facing the back sheet 10.

### Translucent base member 20

The translucent base member 20 supports the translucent conductive layer 21, the power generation layer 22, and the electrode 23. The translucent base member 20 is translucent. The translucent base member 20 may be translucent in such a manner that the light transmittance is 10% or more with respect to the peak wavelength of light prior to incidence, and is preferably 50% or more, more preferably 80% or more. In the present description, "transparent" is defined as having a light transmittance of 80% or more with respect to the peak wavelength of light prior to incidence.

Examples of the material of the translucent base member 20 include an inorganic material, an organic material, and a metal material. Examples of the inorganic material include quartz glass and alkali-free glass. Examples of the organic material include polyethylene terephthalate (PET), polyethylene naphthalene (PEN), polyethylene, polyimide, polyamide, polyamideimide, liquid crystal polymers, cyclo-olefin polymers, and other plastics and polymer films. Examples of the metal material include stainless steel, aluminum, titanium, and silicon.

The thickness of the translucent base member 20 is not particularly limited as long as the translucent base member 20 can support the translucent conductive layer 21, the power generation layer 22, and the electrode 23, and the thickness of the translucent base member 20 is, for example, 10 µm or more and 300 µm or less.

The translucent base member 20 is a base member required in the manufacturing process of the power generation cell 110, but is not necessarily a required part of the configuration. For example, the translucent base member 20 may be used only during the manufacturing of the photovoltaic power generation sheet 4, or may be removed after or during the manufacturing. When removed, a base member that is not translucent may be used instead of the translucent base member 20.

### Translucent conductive layer 21

The translucent conductive layer 21 is a layer that is conductive and functions as a cathode. The translucent conductive layer 21 is translucent. The translucent conductive layer 21 is preferably transparent.

Examples of the translucent conductive layer 21 include indium tin oxide (ITO), fluorine-doped tin oxide (FTO), nesa films, and other transparent materials. The translucent conductive layer 21 is formed on the surfaces 5 and 6 of a translucent substrate by, for example, a sputtering method, an ion plating method, a plating method, a coating method, or the like.

In addition, the translucent conductive layer 21 may be configured to be translucent by forming a pattern capable of transmitting light while using a material that is not translucent. Examples of the material that is not translucent include platinum, gold, silver, copper, aluminum, rhodium, indium, titanium, nickel, tin, zinc, and alloys containing these metals. Examples of the pattern capable of transmitting light include a lattice shape, a linear shape, a wavy line shape, a honeycomb shape, and a round hole shape.

The thickness of the translucent conductive layer 21 is preferably, for example, 30 nm or more and 300 nm or less. When the translucent conductive layer 21 has a thickness of 30 nm or more and 300 nm or less, excellent conductivity can be obtained while high flexibility is maintained.

### Power generation layer 22

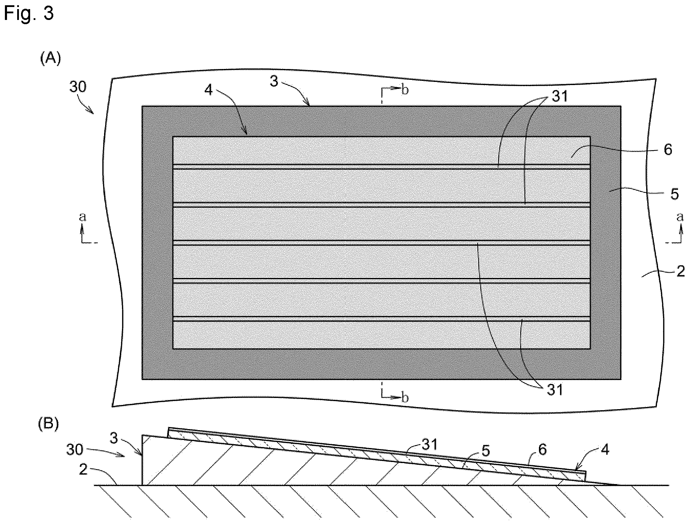

The power generation layer 22 is a layer that causes photoelectric conversion by light irradiation, producing electrons and holes from excitons generated by light absorption. As illustrated in Fig. 3(B), the power generation layer 22 includes a hole transport layer 221, a photoelectric conversion layer 222, and an electron transport layer 223. The hole transport layer 221, the photoelectric conversion layer 222, and the electron transport layer 223 are stacked in this order in a direction from the translucent conductive layer 21 toward the electrode 23.

### Hole transport layer 221

The hole transport layer 221 extracts holes generated in the photoelectric conversion layer 222 to the translucent conductive layer 21, and prevents electrons generated in the photoelectric conversion layer 222 from moving to the translucent conductive layer 21. As a material of the hole transport layer 221, for example, a metal oxide can be used. Examples of the metal oxide include titanium oxide, molybdenum oxide, vanadium oxide, zinc oxide, nickel oxide, lithium oxide, calcium oxide, cesium oxide, and aluminum oxide. In addition, a delafosite-type compound semiconductor (CuGaCt), copper oxide, copper thiocyanate (CuSCN), vanadium pentoxide (V₂O₅), graphene oxide, or the like may be used. Furthermore, as a material of the hole transport layer 221, a p-type organic semiconductor or a p-type inorganic semiconductor can also be used.

The thickness of the hole transport layer 221 is, for example, preferably 1 nm or more and 1000 nm or less, more preferably 10 nm or more and 500 nm or less, and still more preferably 10 nm or more and 50 nm or less. As long as the thickness of the hole transport layer 221 is 1 nm or more and 1000 nm or less, hole transport can be realized.

### Photoelectric conversion layer 222

The photoelectric conversion layer 222 (photoactive layer) is a layer that photoelectrically converts absorbed light. The material of the photoelectric conversion layer 222 is not particularly limited as long as the photoelectric conversion layer 222 can photoelectrically convert absorbed light, and for example, amorphous silicon, perovskite, a non-silicon-based material (semiconductor material CIGS), or the like is used. In addition, the photoelectric conversion layer 222 may have a tandem stacked structure that composites these materials. For the photoelectric conversion layer 222 using a non-silicon-based material, a semiconductor material CIGS containing copper (Cu), indium (In), gallium (Ga), and selenium (Se) is used, and the thickness of the photoelectric conversion layer is easily reduced.

Hereinafter, as an example of the photoelectric conversion layer 222, a photoelectric conversion layer using perovskite will be described. The photoelectric conversion layer 222 containing a perovskite compound has an advantage that dependence of power generation efficiency on an angle of incident light (hereinafter, there may be referred to as dependence on the incident angle) is relatively low. As a result, in the present embodiment, since the dependency on the gradient of the installation surface is small, the photoelectric conversion layer 222 can be installed in a broader location as compared with that in other solar cells, so that higher power generation efficiency can be obtained.

The perovskite compound is a structure having a perovskite crystal structure and a crystal similar thereto. The perovskite crystal structure is represented by the composition formula ABX₃. In this composition formula, for example, A represents an organic cation, B represents a metal cation, and X represents a halogen anion. Here, the A site, the B site, and the X site are not limited thereto.

The organic group of the organic cation of the A site is not particularly limited, and examples thereof include alkylammonium derivatives and formamidinium derivatives. The organic cation of the A site may be one kind or two or more kinds.

The metal of the metal cation of the B site is not particularly limited, and examples thereof include Cu, Ni, Mn, Fe, Co, Pd, Ge, Sn, Pb, and Eu. The metal cation of the B site may be one kind or two or more kinds.

The halogen of the halogen anion of the X site is not particularly limited, and examples thereof include F, Cl, Br, and I. The halogen anion of the X site may be one kind or two or more kinds.

The thickness of the photoelectric conversion layer 222 is, for example, preferably 1 nm or more and 1 million nm or less, more preferably 100 nm or more and 50,000 nm or less, and still more preferably 300 nm or more and 1000 nm or less. When the thickness of the photoelectric conversion layer 222 is 1 nm or more and 1 million nm or less, the photoelectric conversion efficiency is improved.

### Electron transport layer 223

The electron transport layer 223 extracts electrons generated in the photoelectric conversion layer 222 to the electrode 23, and prevents holes generated in the photoelectric conversion layer 222 from moving to the electrode 23. The electron transport layer 223 preferably contains, for example, either a halogen compound or a metal oxide.

Examples of the halogen compound include lithium halide (LiF, LiCl, LiBr, LiI) and sodium halide (NaF, NaCl, NaBr, NaI). Examples of the element of the metal oxide include titanium, molybdenum, vanadium, zinc, nickel, lithium, potassium, cesium, aluminum, niobium, tin, and barium. As a material of the electron transport layer 223, an n-type organic semiconductor or an n-type inorganic semiconductor can also be used.

The thickness of the electron transport layer 223 is, for example, preferably 1 nm or more and 1000 nm or less, more preferably 10 nm or more and 500 nm or less, and still more preferably 10 nm or more and 50 nm or less. As long as the thickness of the electron transport layer 223 is 1 nm or more and 1000 nm or less, electron transport can be realized.

### Electrode 23

The electrode 23 is conductive and functions as an anode. The electrode 23 can extract electrons from the photoelectric conversion layer 222 according to photoelectric conversion generated by the photoelectric conversion layer 222. The electrode 23 may be translucent or may be made of a material that is not translucent. Examples of the material of the electrode 23 include platinum, gold, silver, copper, aluminum, rhodium, indium, titanium, nickel, tin, zinc, and alloys containing these metals.

### Barrier sheet 12

The barrier sheet 12 is disposed on a side opposite to the back sheet 10 in the thickness direction of the photovoltaic power generation sheet 4. The barrier sheet 12 is translucent, and the above-described "the surface 6 of the photovoltaic power generation sheet 4 having a critical surface tension γc of 20 or more and 45 or less and inclined at an angle of 1.5° or more with respect to the horizontal plane" is constituted by the surface of the barrier sheet 12. The barrier sheet 12 is preferably transparent. The barrier sheet 12 has barrier performance against water vapor and protection performance against external force.

The barrier sheet 12 is flexible. As a material used for the barrier sheet 12, a modulus of longitudinal elasticityis preferably 100 Pa or more and 10,000 MPa or less, and more preferably 1000 MPa or more and 5000 MPa or less. Specific examples of the material of the barrier sheet 12 include a plastic film and a vinyl film.

The thickness of the barrier sheet 12 is preferably 50 µm or more, and more preferably 100 µm or more. The thickness of the barrier sheet 12 is preferably 2000 µm or less, and more preferably 1000 µm or less. The thickness of the barrier sheet 12 being 50 µm or more and 2000 µm or less makes it easy to set the flexural strength of the photovoltaic power generation sheet 4 to be 50 MPa or more and 150 MPa or less.

When the photovoltaic power generation sheet 4 is heated or cooled, the thermal expansion/contraction amount of the barrier sheet 12 is preferably close to the thermal expansion/contraction amount of the back sheet 10. That is, the ratio of the thermal expansion coefficient of the barrier sheet 12 to the thermal expansion coefficient of the back sheet 10 is preferably 6.0 or less, more preferably 3.0 or less, and still more preferably 1.0 or less. On the other hand, the lower limit value of the ratio of the thermal expansion coefficient of the barrier sheet 12 to the thermal expansion coefficient of the back sheet 10 is preferably 0.8 or more, more preferably 0.9 or more, and still more preferably 0.95 or more.

As a result, when the temperature rises due to the influence of sunlight or the temperature drops in the wintertime after installation, the influence of thermal expansion/contraction occurring in the photovoltaic power generation sheet 4 can be reduced. As a result, it is possible to reduce the shear stress generated at the interface between the back sheet 10 and the sealant 13 and the interface between the barrier sheet 12 and the sealant 13.

### Sealant 13

The sealant 13 is filled between the barrier sheet 12 and the back sheet 10 in a state where the power generation layer 22 is disposed between the barrier sheet 12 and the back sheet 10. The sealant 13 prevents water from entering the power generation layer 22 from around the power generation layer 22. The sealant 13 is translucent and is preferably transparent. The sealant 13 does not necessarily cover the entire power generation layer 22. For example, in a case where a part of power generation layer 22 is exposed from sealant 13, the exposed portion may be covered with sealing edge member 14 or the like.

Examples of the material of the sealant 13 include ethylene vinyl acetate (EVA), polyolefin, butyl rubber, silicone resin, polyvinyl butyral, acrylic resin, polyisobutylene resin, SBS resin, SIBS resin, epoxy resin, and the like.

The modulus of transverse elasticity of the sealant 13 is preferably 0.01 or more and 500 MPa or less, more preferably 0.05 or more and 250 MPa or less, and still more preferably 0.1 or more and 100 MPa or less. In this way, the shear stress in the surface direction due to thermal expansion/contraction caused by a temperature difference between the back sheet 10 and the barrier sheet 12 can be absorbed by the sealant 13 being deformed in the surface direction. As a result, it is possible to suppress the occurrence of peeling due to the shear stress generated by thermal expansion/contraction between the back sheet 10 and the barrier sheet 12. The "modulus of transverse elasticity" referred to in the present application is, for example, a value calculated from a modulus of longitudinal elasticity and a Poisson's ratio obtained by a tensile test method.

The sealant 13 can also be defined by its viscosity from another point of view. The viscosity of the sealant 13 is preferably 11000 mPa·s or more and 700,000 mPa·s or less, more preferably 26000 mPa·s or more and 450,000 mPa·s or less, and still more preferably 40,000 mPa·s or more and 110,000 mPa·s or less.

Examples of the material of the sealant 13 in this case include polyolefin, butyl rubber, silicone resin, polyvinyl butyral, acrylic resin, polyisobutylene resin, and the like. The term "viscosity" as used herein refers to a value measured at an environmental temperature of 23°C in accordance with the rotational viscometer method of JIS Z8803.

The back sheet 10 and the barrier sheet 12 are bonded to each other with the sealant 13 interposed therebetween, and the bonding strength is preferably 0.1 N/10 mm or more and 10 N/10 mm or less in a peel test. In particular, in a case where the photovoltaic power generation sheet 4 is constructed in a bent state, the shearing stress generated in the photovoltaic power generation sheet 4 becomes larger, and thus, it is possible to effectively suppress peeling for a long period by adopting the bonding strength in the above range in the peel test. The peel test is performed in accordance with JIS Z 0237.

From the viewpoint of enhancing the effect of suppressing peeling, the thickness of the sealant 13 is preferably 10 µm or more, more preferably 30 µm or more, and still more preferably 50 µm or more. On the other hand, the thickness of the sealant 13 is preferably 300 µm or less, more preferably 200 µm or less, and still more preferably 100 µm or less. Setting the thickness of the sealant 13 to 10 µm or more can ensure sufficient escape path for the shear stress during thermal expansion/contraction. Setting the thickness of the sealant 13 to 300 µm or less allows the weight of the photovoltaic power generation sheet 4 to be reduced, thereby improving the ease of construction and workability.

### Sealing edge member 14

The sealing edge member 14 seals between an outer peripheral edge 15 of the back sheet 10 and an outer peripheral edge 16 of the barrier sheet 12 in a state where a plurality of power generation cells 110 and the sealant 13 are disposed between the back sheet 10 and the barrier sheet 12. An outer peripheral edge 17 of the photovoltaic power generation sheet 4 is constituted by the outer peripheral edge of the sealing edge member 14. As illustrated in Fig. 2, the sealing edge member 14 includes a first bonding portion 101, a second bonding portion 102, and a sealing portion 103 connecting the first bonding portion 101 and the second bonding portion 102. The first bonding portion 101 is bonded to a surface (upper surface in the drawing) of the barrier sheet 12. The second bonding portion 102 is bonded to a back surface (lower surface in the drawing) of the back sheet 10. The first bonding portion 101, the sealing portion 103, and the second bonding portion 102 are integrally formed.

Examples of the material of the sealing edge member 14 include a tape material made of butyl rubber, silicone rubber, or the like.

In the present embodiment, the sealing edge member 14 is not necessarily required. For example, instead of the sealing edge member 14, an edge portion of the barrier sheet 12 may be bent toward the back sheet 10, and a bent tip may be joined to the back sheet 10. This eliminates the need for the sealing edge member 14.

### Action of photovoltaic power generation sheet 4

When the photovoltaic power generation sheet 4 is irradiated with light from the surface 6 side (barrier sheet 12 side) of the photovoltaic power generation sheet 4, the photoelectric conversion layer 222 of the power generation layer 22 absorbs light and performs photoelectric conversion, so that electrons and holes are generated in the photoelectric conversion layer 222. When the electrons are extracted to the electrode 23 (anode) via the electron transport layer 223 and holes are extracted to the translucent conductive layer 21 (cathode) via the hole transport layer 221, a current flows from the translucent conductive layer 21 to the electrode 23 (that is, power generation is performed).

In the photoelectric conversion unit of power generator 11, an extension portion 23a is provided in the electrode 23 (anode) of each power generation cell 110 (Fig. 2(C)). The extension portion 23a of the electrode 23 extends toward the translucent conductive layer 21 (cathode) side. In two adjacent power generation cells 110, 110, the extension portion 23a of the electrode 23 of one cell 110 is joined to the translucent conductive layer 21 of the other cell 110. By this joining, while the photovoltaic power generation sheet 4 is irradiated with light, a current flows from the translucent conductive layer 21A at one side end of the power generator 11 (photoelectric conversion unit) to the electrode 23A at the other side end of the power generator 11 (the flow of the current is indicated by an arrow in Fig. 2(C)). The current is extracted via a power distribution line (not illustrated).

In a case where the power generator 11 is configured by the photoelectric conversion unit described above, when a failure occurs in some of the power generation cells 110, the amount of electricity extracted from the power generator 11 can still be stabilized.

Instead of providing the extension portion 23a on the electrode 23 (anode) of each power generation cell 110, an extension portion extending toward the electrode 23 (anode) side may be provided on the translucent conductive layer 21 (cathode) of each power generation cell 110. In this case, in two adjacent power generation cells 110, 110, the extension portion of the translucent conductive layer 21 of one cell 110 is joined to the electrode 23 of the other cell 110. In this case, the same effect as described above can still be obtained.

In a case where the translucent base member 20 is provided in the power generator 11, it is preferable to support the translucent conductive layer 21, the power generation layer 22, and the electrode 23 of each power generation cell 110 on the common translucent base member 20 as illustrated in Fig. 2(C) from the viewpoint of facilitating the manufacturing of the power generator 11.

In addition, in a case where the power generator 11 includes one power generation cell 110, the current flowing from the electrode 23 to the translucent conductive layer 21 is extracted via a power distribution line.

The photovoltaic power generation sheet 4 may include a plurality of power generators 11. In this case, the plurality of power generators 11 are arranged in the surface direction of the photovoltaic power generation sheet 4 and are electrically connected in series or in parallel.

In a case where the power generator 11 includes a photoelectric conversion unit, in order to connect the plurality of power generators 11 in series, for two adjacent power generators 11, 11, the translucent conductive layer 21A at the end of one power generator 11 and the electrode 23A at the end of the other power generator 11 are connected via a power distribution line. In a case where the plurality of power generators 11 are connected in parallel, the translucent conductive layers 21A, 21A at the ends of two adjacent power generators 11, 11 and the electrodes 23A, 23A at the ends of the two adjacent power generators 11, 11 are connected via a power distribution line, respectively.

In addition, in a case where the power generator 11 includes one power generation cell 110, in order to connect the plurality of power generators 11 in series, for two adjacent power generators 11, 11, the translucent conductive layer 21 of one power generator 11 and the electrode 23 of the other power generator 11 are connected via a power distribution line. In a case where the plurality of power generators 11 are connected in parallel, the translucent conductive layers 21, 21 of two adjacent power generators 11, 11 and the electrodes 23, 23 of the two adjacent power generators 11, 11 are connected via a power distribution line, respectively.

Note that in a case where the power generator 11 includes any one of the photoelectric conversion unit and one power generation cell 110, the distance between adjacent power generators 11, 11 may be more than 0 mm, preferably 2 mm or more, more preferably 10 mm or more, and still more preferably 15 mm or more. The distance between adjacent power generators 11, 11 is preferably 100 mm or less, more preferably 50 mm or more, and still more preferably 20 mm or less.

### Operation and effect

According to the installation structure 1 according to the present embodiment, the surface 6 of the photovoltaic power generation sheet 4 (the surface of the barrier sheet 12) is inclined at an angle of 1.5° or more with respect to the horizontal plane, and the surface 6 of the photovoltaic power generation sheet 4 (the surface of the barrier sheet 12) has smoothness that the critical surface tension γc is 20 or more, so that moisture such as rainwater dropped on the surface 6 of the photovoltaic power generation sheet 4 flows in the inclination direction of the surface 6. As a result, moisture is removed from the surface 6 of the photovoltaic power generation sheet 4, so that adhesion of dirt contained in the moisture to the surface 6 can be suppressed. Therefore, since it is possible to prevent sunlight from being blocked by the dirt, it is possible to maintain the power generation efficiency of the photovoltaic power generation sheet 4.

Further, since the surface 6 of the photovoltaic power generation sheet 4 (the surface of the barrier sheet 12) has a roughness that the critical surface tension γc is 45 or less, it is possible to prevent a pedestrian or a vehicle from slipping on the surface 6 of the photovoltaic power generation sheet 4.

Further, since the photovoltaic power generation sheet 4 is flexible, it is possible to prevent the power generation cell 110 from being broken when the weight of a person, a vehicle, or the like is loaded on the photovoltaic power generation sheet 4.

Hereinafter, another embodiment of the present invention will be described. Hereinafter, differences from the first embodiment will be mainly described, and points common to the first embodiment will be denoted by the same reference numerals, and description thereof will be omitted.

### Second embodiment

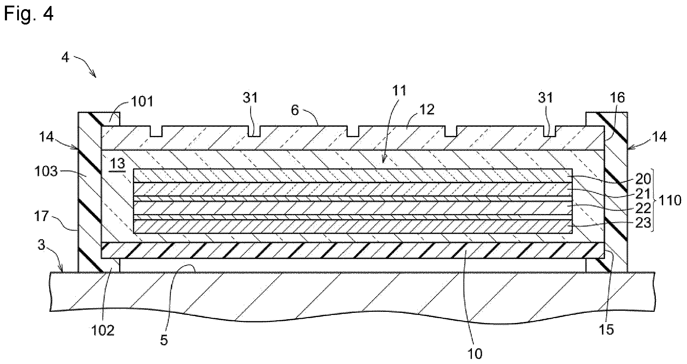

Fig. 3(A) is a schematic plan view illustrating an installation structure 30 for a photovoltaic power generation sheet 4 according to a second embodiment of the present invention, and Fig. 3(B) is a schematic cross-sectional view taken along line a-a in Fig. 3(A) . Fig. 4 is a schematic cross-sectional view taken along line b-b in Fig. 3(A).

In the installation structure 30 according to the second embodiment, a groove 31 is formed on the surface 6 of the photovoltaic power generation sheet 4 (the surface of the barrier sheet 12). The groove 31 extends in a direction in which the surface 6 of the photovoltaic power generation sheet 4 is inclined (hereinafter, it is appropriately referred to as "inclination direction of the surface 6"). According to the installation structure 30 according to the second embodiment, moisture on the surface 6 of the photovoltaic power generation sheet 4 can be easily made to flow by the guide of the groove 31.

In the installation structure 30 according to the second embodiment, as illustrated in Fig. 3, it is preferable to form the groove 31 over the entire length of the surface 6 in the "inclination direction of the surface 6". In this way, since moisture can flow by the guide of the groove 31 over the entire length of the surface 6, the moisture can be smoothly discharged from the surface 6. In a case where the groove 31 is formed over the entire length of the surface 6 (the entire length of the surface of the barrier sheet 12) as described above, it is preferable to form a groove communicating with the groove 31 in the sealing edge member 14. In this way, the moisture guided to the groove 31 can be smoothly discharged to the outside of the photovoltaic power generation sheet 4 through the groove of the sealing edge member 14.

As illustrated in Fig. 3, it is preferable to form a plurality of grooves 31 at intervals in a direction orthogonal to the inclination direction of the surface 6. In this way, the range of the surface 6 that can guide moisture by the grooves 31 can be expanded. The width, depth, and number of the grooves 31 can be appropriately set according to the dimensions and the like of the photovoltaic power generation sheet 4. Since the grooves 31 have a function of collecting and flowing dirt, it is desirable not to provide the grooves 31 on the power generation cell 110 in the photovoltaic power generation sheet 4. That is, when the grooves 31 are provided between power generation cells 110 and power generation cells 110 adjacent to each other in the photovoltaic power generation sheet 4, or between the photoelectric conversion unit and the photoelectric conversion unit adjacent to each other in a case where a plurality of aggregation units (photoelectric conversion units) of the power generation cells 110 are provided, or on a power distribution line or the like for extracting electricity, it is possible to further prevent a decrease in power generation efficiency.

### Third embodiment

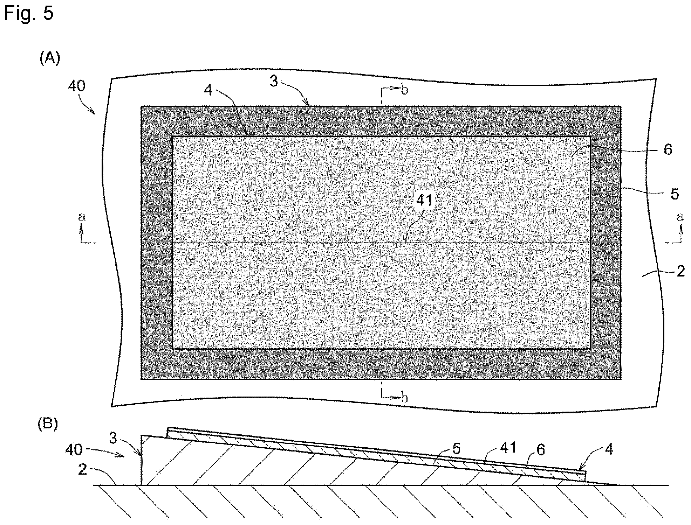

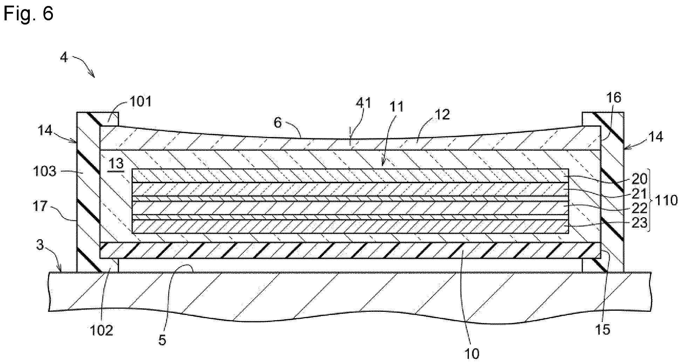

Fig. 5(A) is a schematic plan view illustrating an installation structure 40 for a photovoltaic power generation sheet according to a third embodiment of the present invention, and Fig. 5(B) is a schematic cross-sectional view taken along line a-a in Fig. 5(A) . Fig. 6 is a schematic cross-sectional view taken along line b-b in Fig. 5(A) .

In the installation structure 40 of the photovoltaic power generation sheet according to the third embodiment, in the "cross section perpendicular to the direction in which the surface 6 of the photovoltaic power generation sheet 4 is inclined", the surface 6 of the photovoltaic power generation sheet 4 has an arc shape recessed downward (Fig. 6 shows the above "cross section perpendicular to the direction in which the surface 6 of the photovoltaic power generation sheet 4 is inclined").

According to the installation structure 40 according to the third embodiment, the moisture dropped on the surface 6 of the photovoltaic power generation sheet 4 can flow in the inclination direction of the surface 6 while being collected in the vicinity of the bottom portion 41 of the arc of the surface 6. As a result, it is possible to reliably narrow the range of the photovoltaic power generation sheet 4 in which power generation is hindered by dirt contained in the moisture.

In the examples illustrated in Figs. 5 and 6, the surface 6 of the photovoltaic power generation sheet 4 is processed into an arc shape, but the surface 6 of the photovoltaic power generation sheet 4 may be formed into an arc shape recessed downward by installing the photovoltaic power generation sheet 4 flexed in an arc shape on the surface 5 of the support member 3.

### Modifications

The present invention is not limited to the above embodiment, and various modifications can be made.

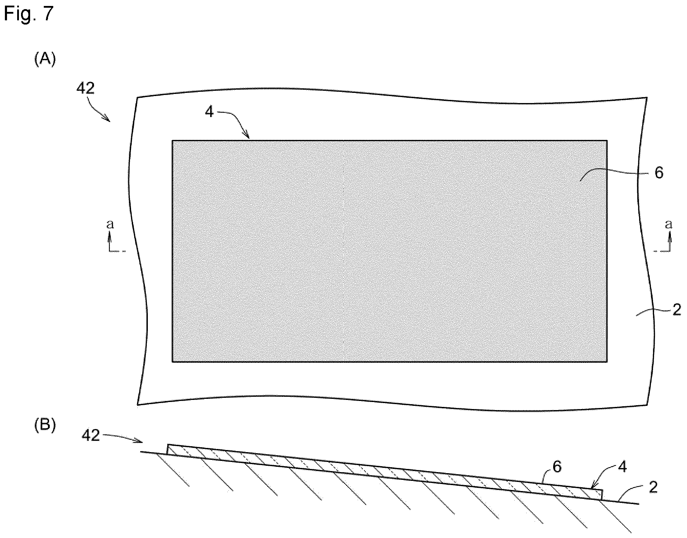

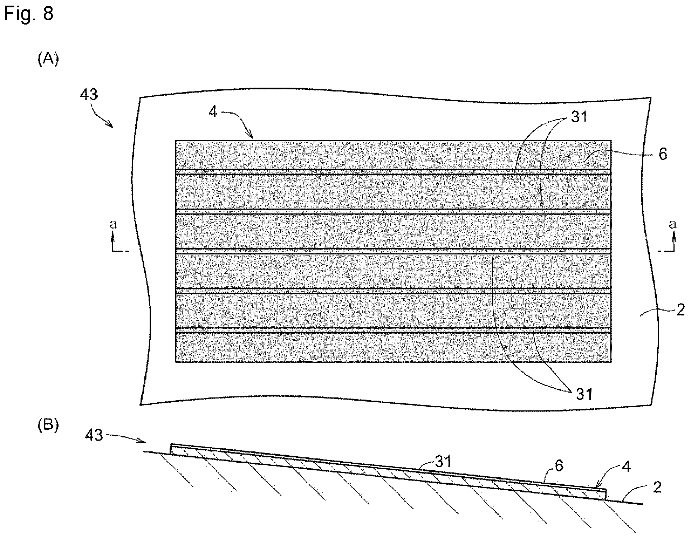

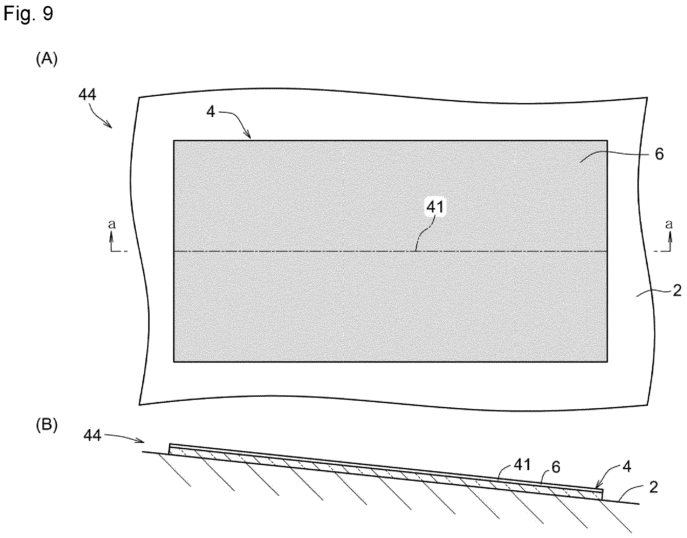

For example, the installation structure 1 according to the first embodiment illustrated in Figs. 1 and 2 can be changed as illustrated in Fig. 7. In addition, the installation structure 30 according to the second embodiment illustrated in Figs. 3 and 4 can be changed as illustrated in Fig. 8. In addition, the installation structure 40 according to the third embodiment illustrated in Figs. 5 and 6 can be changed as illustrated in Fig. 9. In the installation structures 42,43, and 44 of the photovoltaic power generation sheets illustrated in Figs. 7 to 9, the support member 3 illustrated in Figs. 1 to 6 is omitted, and the photovoltaic power generation sheet 4 is installed on the installation surface 2. Since the installation surface 2 is inclined at an angle of 1.5° or more with respect to the horizontal plane, the surface 6 of the photovoltaic power generation sheet 4 installed on the installation surface 2 is also inclined at an angle of 1.5° or more with respect to the horizontal plane. The photovoltaic power generation sheet 4 is fixed to the installation surface 2 using a fixing member (not illustrated). The fixing member is not particularly limited, and examples thereof include a bolt, a screw, a clip, a bonder, a magnet, a pin, a nail, and a weight. Also in the installation structures 42,43, and 44 according to the above modifications, the same effects as those of the embodiments can be obtained.

In the above embodiments, as one aspect of the photovoltaic power generation sheet, the photovoltaic power generation sheet having the photoelectric conversion layer containing the perovskite compound has been described, and in the present invention, a photovoltaic power generation sheet being flexible can exhibit the same effect. In addition, the photovoltaic power generation sheet according to the present invention may be not only a solar cell that can obtain a power generation effect by light, but also a sheet that converts light energy into another energy. For example, the photovoltaic power generation sheet may be a light heating sheet (photovoltaic power-driven thermoelectric conversion device) that converts light energy into thermal energy.

In the installation structure for the present invention, the surface of the photovoltaic power generation sheet 4 may include a surface inclined at an angle of 1.5° or more with respect to the horizontal plane. That is, in the above example, a case where the entire surface of the photovoltaic power generation sheet 4 is inclined at an angle of 1.5° or more with respect to the horizontal plane has been described, and a part of the surface of the photovoltaic power generation sheet 4 may be inclined at an angle of 1.5° or more with respect to the horizontal plane. In this case, moisture such as rainwater flows in the inclination direction and is removed on a part of the surface of the sheet 4, and adhesion of dirt contained in the moisture can be suppressed. Therefore, it is possible to suppress blocking of sunlight by dirt as compared with a case where the entire surface of the photovoltaic power generation sheet 4 is horizontal. The surface of the photovoltaic power generation sheet 4 may include a plurality of surfaces inclined at the above angle in different directions. In this case, it is preferable to set the inclination directions of the plurality of surfaces so that no moisture accumulation locations are formed on the surface of the solar cell sheet.

In addition, the installation surface 2 may be an inclined surface of a mountain, a slope surface of an embankment, a cover of a precipitation pond and the like, or a surface of a structure such as a vinyl house, an automobile, an aircraft, a train, a ship, a cargo bed of a truck, or the like. The material of the member of the installation surface 2 is not particularly limited, and may be, for example, metal, hard resin, asphalt, or concrete. The arithmetic average roughness of the installation surface 2 measured by JISB0601 is preferably 5 mm or less, more preferably 1 mm or less, still more preferably 0.5 mm or less, and preferably 100 nm or more, more preferably 0.1 µm or more, still more preferably 0.1 µm or more. As long as the roughness of the installation surface 2 is within the above range, it is possible to suppress blowing of wind from the end portion of the photovoltaic power generation sheet according to the present invention. In addition, it is possible to obtain a fixing force of the bonder by the anchor effect with the unevenness.

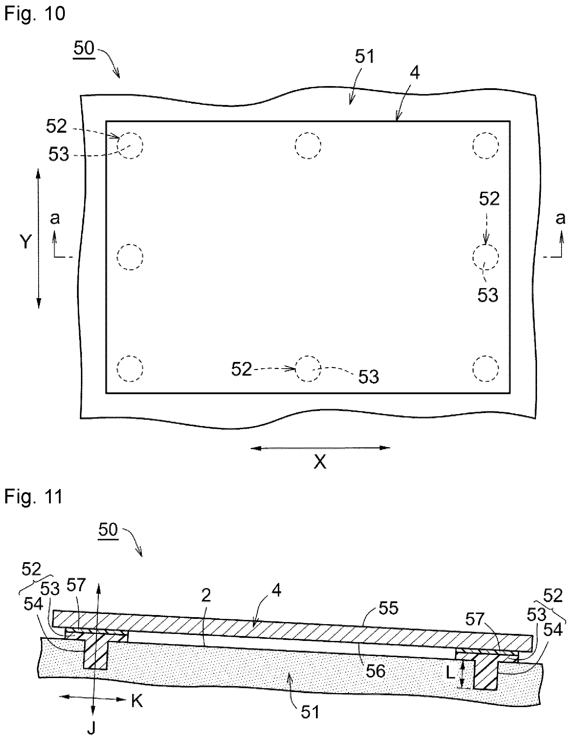

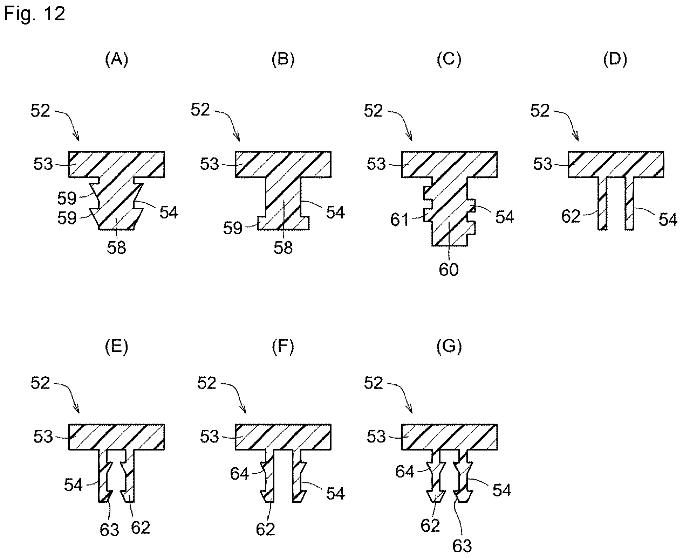

Further, the installation structure for the photovoltaic power generation sheet of the present invention can be modified as illustrated in Figs. 10 and 11. The installation structure 50 of the photovoltaic power generation sheet illustrated in Figs. 11 and 12 includes an installation surface 2, a photovoltaic power generation sheet 4 provided on an upper side of the installation surface 2, and a fixture 52 for fixing the photovoltaic power generation sheet 4 to a fixation target 51 serving as the installation surface 2. Hereinafter, a case where the fixation target 51 is the ground will be described, and the present invention does not limit the fixation target 51 to the ground. The fixation target 51 may be various objects (covers of buildings, banks, sedimentation ponds, and the like, vinyl houses, automobiles, airplanes, trains, ships, truck carriers, and the like) of the installation surface 2 described above.

### Fixture 52

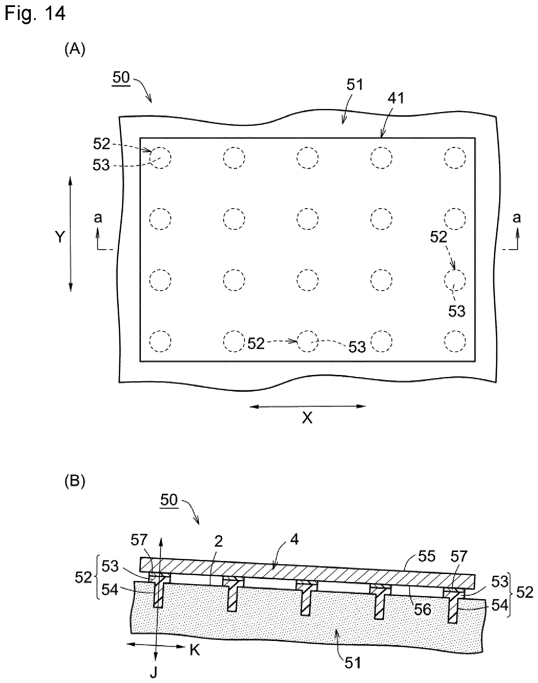

As illustrated in Fig. 11, the fixture 52 includes an exposed portion 53 exposed from the fixation target 51 and an embedded portion 54 provided integrally with the exposed portion 53 and embedded in the fixation target 51. The exposed portion 53 is bonded to a surface 56 of the photovoltaic power generation sheet 4 on the opposite side of the light receiving surface 55 with a bonding layer 57 interposed therebetween. Fig. 10 illustrates an example in which the fixtures 52 are provided at the four corner portions and the center of each side of the photovoltaic power generation sheet 4, and the number and positions of the fixtures 52 are not limited to the illustrated example. Any number of the fixtures 52 can be provided at any position, as long as the photovoltaic power generation sheet 4 can be fixed. For example, as illustrated in Figs. 14(A) and 14(B), a plurality of fixtures 52 may be provided at equal intervals in the longitudinal direction X and the width direction Y of the photovoltaic power generation sheet 4.

The material of the fixture 52 is not particularly limited, and for example, it is preferable to form the fixture 52 using resin. In this way, when the fixture 52 scatters, damage to the peripheral portion by the fixture 52 can be suppressed. As the resin for forming the fixture 52, for example, polypropylene, polyvinyl chloride, or polyphenylene sulfide can be used. The fixture 52 may be formed using resin reinforced with fibers. The color of the fixture 52 is preferably black from the viewpoint of weatherability.

### Buried portion 54

The embedded portion 54 extends downward from the center of gravity of the exposed portion 53, and is embedded in the fixation target 51 (ground). In the present modification, the embedded portion 54 has a columnar shape, and the shape of the embedded portion 54 is not particularly limited as long as the embedded portion 54 can be embedded in fixation target 51. For example, the embedded portion 54 may have a prismatic shape.

As illustrated in Figs. 12(A) and 12(B), the embedded portion 54 may include a main body portion 58 having a columnar or plate shape and extending from the exposed portion 53, and one or a plurality of protruding portions 59 protruding annularly from the outer peripheral surface of the main body portion 58. As illustrated in Fig. 12(A), in a case where a plurality of protruding portions 59 are provided in the embedded portion 54, the plurality of protruding portions 59 are provided at intervals in the longitudinal direction of the main body portion 58. In a case where one protruding portion 59 is provided as illustrated in Fig. 12(B), for example, the protruding portion 59 is provided at an end portion (lower end portion of the main body 58) on a side opposite to the exposed portion 53 in the main body portion 58. In a case of providing the protruding portion 59, it is preferable to increase the outer diameter of the protruding portion 59 toward the exposed portion 53 side (upper side). This makes it possible to achieve both the ease of insertion of the embedded portion 54 into the fixation target 51 and the difficulty of removal of the embedded portion 54 from the fixation target 51.

As illustrated in Fig. 12(C), the embedded portion 54 may include a main body portion 60 having a columnar shape and extending from the exposed portion 53, and a screw portion 61 having a spiral shape and formed on an outer peripheral surface of the main body portion 60. In this case, the embedded portion 54 is embedded in the fixation target 51 by screwing the embedded portion 54 into the fixation target 51.

As illustrated in Figs. 12(D), 12(E), 12(F), and 12(G), the embedded portion 54 may include a main body portion 62 having a cylindrical shape and extending from the exposed portion 53. In this way, it is possible to secure a large area where the embedded portion 54 is in contact with the fixation target 51, and thus, it is possible to improve the force with which the photovoltaic power generation sheet 4 is fixed to the fixation target 51 by the fixture 52.

As illustrated in Fig. 12(E), the embedded portion 54 may further include one or a plurality of protruding portions 63 protruding annularly from the inner peripheral surface of the main body portion 62. As illustrated in Fig. 12(F), the embedded portion 54 may include one or a plurality of protruding portions 64 protruding annularly from the outer peripheral surface of the main body portion 62. As illustrated in Fig. 12(G), the embedded portion 54 may include one or a plurality of protruding portions 63 and 64 protruding annularly from the inner peripheral surface and the outer peripheral surface of the main body portion 62, respectively. As described above, the force with which the photovoltaic power generation sheet 4 is fixed by the fixture 52 can be further improved.

In case where the protruding portion 63 is provided on the inner peripheral surface of the main body portion 62 (Figs. 12(E) and 12(G)), it is preferable to provide the protruding portion 63 such that the inner diameter of the protruding portion 63 decreases toward the exposed portion 53 side (upper side). In a case where the protruding portion 64 is provided on the outer peripheral surface of the main body portion 62 (Figs. 12(F) and 12(G)), it is preferable to provide the protruding portion 64 such that the outer diameter of the protruding portion 64 increases toward the exposed portion 53 side (upper side).

The length L of the embedded portion 54 is not particularly limited, and is preferably 10 mm or more, more preferably 25 mm or more, and still more preferably 100 mm or more. The length L of the embedded portion 54 is preferably 500 mm or less, and more preferably 200 mm or less.

The portion of the embedded portion 54 extending from the exposed portion 53 may be formed such that the diameter thereof does not change in the extending direction J, or may be formed such that the diameter thereof gradually changes in the extending direction J (for example, the lower end portion may be formed to be tapered). The above-described "portion of the embedded portion 54 extending from the exposed portion 53" corresponds to the entire embedded portion 54 in the example of Fig. 11, and the main body portions 58,35, and 37 in the examples of Figs. 12(A), 12(B), 12(C), 12(D), 12(E), 12(F), and 12(G). As long as the "portion of the embedded portion 54 extending from the exposed portion 53" has a columnar shape or a cylindrical shape, the diameter refers to a diameter or an outer diameter thereof, and in a case where the "portion of the embedded portion 54 extending from the exposed portion 53" does not have a columnar shape or a cylindrical shape, the diameter refers to a diameter of a circumscribed circle of a cross section of the "portion of the embedded portion 54 extending from the exposed portion 53". The cross section refers to a cross section in a direction K orthogonal to the extending direction J of the embedded portion 54.

The diameter of the portion of the embedded portion 54 extending from the exposed portion 53 is not particularly limited, and is preferably 10 mm or more, and more preferably 15 mm or more. The diameter of the portion of the embedded portion 54 extending from the exposed portion 53 is preferably 200 mm or less, and more preferably 150 mm or less. In a case where the cross section of the embedded portion 54 changes in the extending direction J, the above diameter refers to the maximum diameter of the "portion of the embedded portion 54 extending from the exposed portion 53".

### Exposed portion 53

The exposed portion 53 is bonded to the lower surface of the back sheet 10 forming the surface 56 of the photovoltaic power generation sheet 4 or the lower surface of the sealing edge member 14 with the bonding layer 57 interposed therebetween. The diameter of the exposed portion 53 at the lower end is larger than the above-described "diameter of the portion of the embedded portion 54 extending from the exposed portion 53".

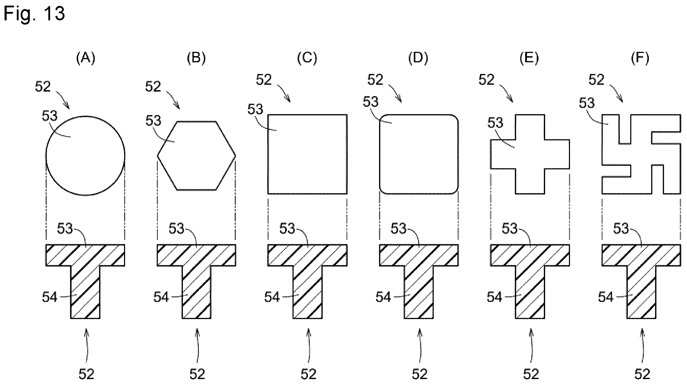

In the present modification, the cross-sectional shape of the exposed portion 53 is circular (Figs. 10 and 13(A)), and the cross-sectional shape of the exposed portion 53 is not particularly limited as long as the exposed portion 53 can be bonded to the photovoltaic power generation sheet 4 by the bonding layer 57. For example, the cross-sectional shape of the exposed portion 53 may be a hexagonal shape (Fig. 13(B)), a square with sharp corners (Fig. 13(C)), a square with rounded corners (Fig. 13(D)), a cross shape (Fig. 13(E)), or a swastika shape (Fig. 13(F)). The above-described cross-sectional shape shape of the exposed portion 53 refers to the shape of the cross section of the exposed portion 53 in the direction K orthogonal to the extending direction J of the embedded portion 54.

The diameter at the upper end of the exposed portion 53 bonded to the surface 56 of the photovoltaic power generation sheet 4 is not particularly limited, and is preferably 30 mm or more, and more preferably 50 mm or more from the viewpoint of widely and firmly bonding the surface 56 of the photovoltaic power generation sheet 4 to the exposed portion 53. The diameter at the upper end of the exposed portion 53 is preferably 500 mm or less, and more preferably 200 mm or less. Note that the "diameter at the upper end of the exposed portion 53" refers to the diameter of the cross section when the shape of the cross section at the upper end of the exposed portion 53 (that is, the upper surface of the exposed portion 53) is circular, and refers to the diameter of the circumscribed circle of the cross section in a case where the cross section at the upper end of the exposed portion 53 (that is, the upper surface of the exposed portion 53) is not circular.

The area of the cross section at the upper end of the exposed portion 53 (that is, the upper surface of the exposed portion 53) is not particularly limited, and is preferably 650mm² or more, and more preferably 2000mm² or more. The area of the cross section at the upper end of the exposed portion 53 (that is, the upper surface of the exposed portion 53) is not particularly limited, and is preferably 200,000mm² or less, and more preferably 20,000mm² or less.

The ratio is not particularly limited between the "diameter at the upper end of the exposed portion 53" and the "diameter of the portion of the embedded portion 54 extending from exposed portion 53 (maximum diameter in a case where the diameter changes in extending direction J of the embedded portion 54)", and in order to bond the surface 56 of the photovoltaic power generation sheet 4 to the exposed portion 53 widely and firmly, the "diameter at the upper end of the exposed portion 53" is preferably 1.1 times or more, and more preferably 1.8 times or more the "diameter of the portion of the embedded portion 54 extending from the exposed portion 53". In addition, the "diameter at the upper end of the exposed portion 53" is preferably 2.5 times or less the "diameter of the portion of the embedded portion 54 extending from the exposed portion 53".

In order to stably maintain the bonding between the photovoltaic power generation sheet 4 and the exposed portion 53, it is preferable that the ratio (S2/S1×100%) of the area S2 of the cross section at the upper end of each exposed portion 53 (that is, the upper surface of each exposed portion 53) to the area S1 of the surface 56 of the photovoltaic power generation sheet 4 is 0.1% or more, more preferably 1% or more, and still more preferably 5% or more, and the ratio (ΣS2/S1×100%) of "sum ΣS2 of the areas S2 of cross sections at upper ends of all exposed portions 53 provided in the installation structure 50" to the area S1 of the surface 56 of the photovoltaic power generation sheet 4 is 5% or more, more preferably 10%, and still more preferably 20%.

In addition, in order to stably maintain the bonding between the photovoltaic power generation sheet 4 and the exposed portion 53, the ratio (S2/S4×100%) of the area S2 of the cross section at the upper end of each exposed portion 53 (that is, the upper surface of each exposed portion 53) to the area S4 (S4=S1-ΣS3) obtained by subtracting the sum ΣS3 of the area S3 of the power generator 11 of the photovoltaic power generation sheet 4 from the area S1 of the surface 56 of the photovoltaic power generation sheet 4 is preferably 10% or more, more preferably 50% or more, and still more preferably 80% or more. Note that it is not always necessary to simultaneously adjust the ratio (S2/S1×100%) and the ratio (ΣS2/S1×100%) to the above values and adjust the ratio (S2/S4×100%) to the above values, and only one of them may be adjusted.

### Bonding layer 57

The bonding layer 57 (Fig. 11) is formed of, for example, a resin composition containing at least one or more selected from a vinyl acetate resin, an ethylene vinyl acetate resin, an epoxy resin, a cyanoacrylate resin, an acrylic resin, a chloroprene rubber, styrene, a butadiene rubber, a polyurethane resin, a silicone resin, and a modified silicone resin. In the present invention, the material of the bonding layer 57 is not limited to the resin composition described above. The bonding layer 57 preferably has a viscosity of 800cP or more, but the viscosity of the bonding layer 57 may be less than 800cP.

### Operation and effect

According to the above modification, since the exposed portion 53 of the fixture 52 is bonded to the surface 56 on the opposite side of the light receiving surface 55 of the photovoltaic power generation sheet 4, the fixture 52 does not block the light directed to the light receiving surface 55 of the photovoltaic power generation sheet 4. Therefore, it is possible to prevent the power generation amount of the photovoltaic power generation sheet 4 from being reduced by the fixture 52.

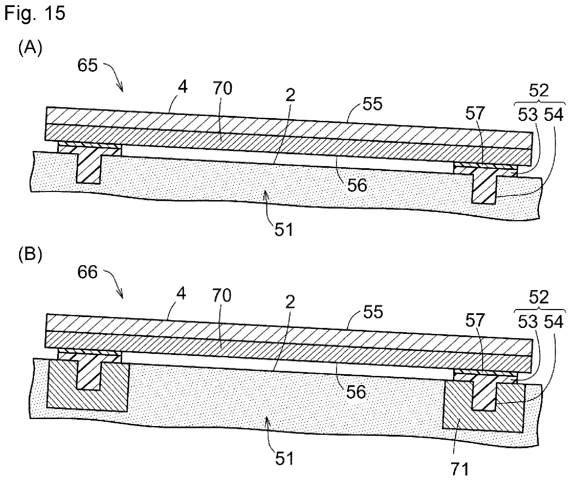

In addition, the installation structure for the photovoltaic power generation sheet of the present invention may be modified as illustrated in Figs. 15(A) and 15(B).

The Installation structures 65 and 66 illustrated in Figs. 15(A) and 15(B) include an installation surface 2, a photovoltaic power generation sheet 4 provided on an upper side of the installation surface 2, and a fiber-containing sheet 70 disposed closer to a fixation target 51 (ground) serving as the installation surface 2 than the power generation sheet 4. In the installation structures 65 and 66, the fiber-containing sheet 70 forms a surface 56 on the opposite side of the light receiving surface 55, and the surface 56 and the exposed portion 53 are bonded to each other with the bonding layer 57 interposed therebetween.

The fiber-containing sheet 70 is a sheet containing fibers. As the fiber-containing sheet 70, a fiber-reinforced sheet in which the periphery of fibers is covered with a resin, or a nonwoven fabric can be used. In this case, for example, polyethylene, polypropylene, polyester, polylactic acid, polyolefin, asphalt, and silica sand are used as the material of fibers contained in the fiber-containing sheet 70. The tensile strength of the fiber-containing sheet 70 is preferably 1 N/cm or more and 10,000 N/cm or less. The thickness of the fiber-containing sheet 70 is preferably, for example, 0.1 mm or more and 100 mm or less. The fiber-containing sheet 70 is bonded to the back sheet 10 (see Fig. 2(A)) of the photovoltaic power generation sheet 4 with an bonding layer (not illustrated) interposed therebetween. As a material of the bonding layer, for example, a resin composition containing at least one or more selected from a vinyl acetate resin, ethylene-acetic acid, a vinyl resin, an epoxy resin, a cyanoacrylate resin, an acrylic resin, a chloroprene rubber, styrene, a butadiene rubber, a polyurethane resin, a silicone resin, and a modified silicone resin can be used. The thickness of the bonding layer is preferably, for example, 0.1 mm or more and 100 mm or less. From the viewpoint of stably maintaining the joining between the fiber-containing sheet 70 and the back sheet 10, the shear peel strength between the fiber-containing sheet 70 and the back sheet 10 with the bonding layer interposed therebetween is preferably 0.1 N/cm or more (the shear peeling strength is a value measured by the method of JIS K6850) .

According to the installation structures 65 and 66 described above, since sunlight is blocked by the fiber-containing sheet 70, it is possible to prevent vegetation from growing on the fixation target 51 (ground) .

In the installation structure 66 illustrated in Fig. 15(B), the embedded portion 54 is embedded in concrete 71 provided in the fixation target 51 (ground). According to the installation structure 66 illustrated in Fig. 15(B), the embedded portion 54 is embedded in the concrete 71, so that the photovoltaic power generation sheet 4 can be fixed by the fixture 52 even when the fixation target 51 is soft ground. In the installation structure 66, it is preferable to use the fixture 52 including the screw portion 61 illustrated in Fig. 12(C). In this case, the fixture 52 is embedded in the concrete 71 by screwing the fixture 52 into a screw hole formed in the concrete 71.

Also in the installation structure 50 illustrated in Figs. 10, 11, and 14, similarly to the installation structure 66 (Fig. 15(B)), the embedded portion 54 may be embedded in the concrete 71 provided in the fixation target 51 (ground).

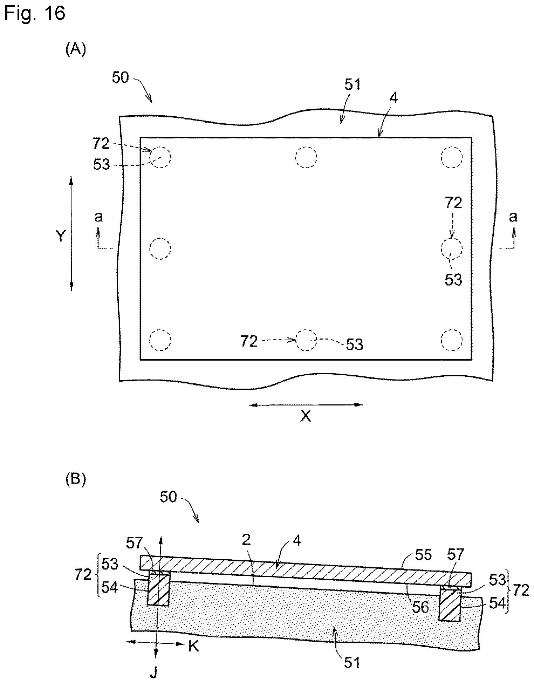

In addition, the fixture included in the installation structure for the present invention is not limited to the fixture 52 described above, and can be modified, for example, as illustrated in Figs. 16 to 18. Figs. 16, 17, and 18 illustrate examples in which each of the fixtures 72, 73, and 74 of each modification are applied to the above-described installation structure 50, and each of the fixtures 72, 73, and 74 of each modification can also be applied to the installation structures 65 and 66 illustrated in Figs. 15(A) and 15(B). Similarly to the fixture 52, the fixtures 72, 73, and 74 are also formed using a resin such as polypropylene, polyvinyl chloride, or polyphenylene sulfide, for example. In addition, the color of the fixtures 72, 73, and 74 is preferably black from the viewpoint of weatherability.

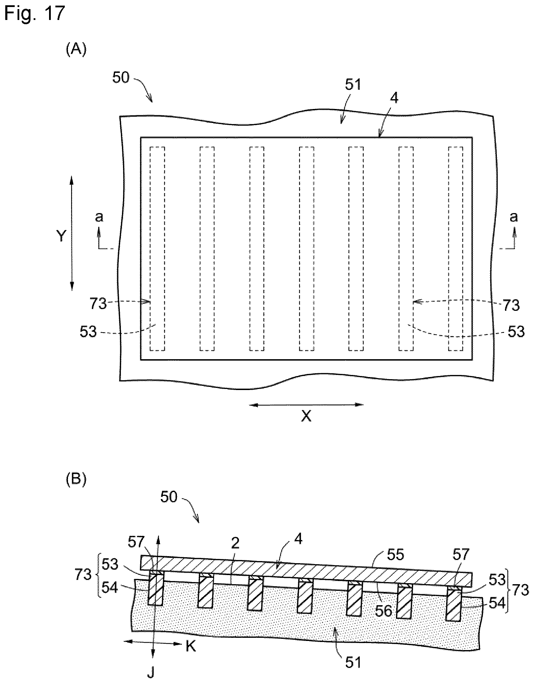

In the fixtures 72 and 73 illustrated in Figs. 16 and 17, the cross sections of the exposed portion 53 and the embedded portion 54 in the direction K orthogonal to the extending direction J of the embedded portion 54 have the same shape.

In the fixture 72 illustrated in Fig. 16, the exposed portion 53 and the embedded portion 54 have the same circular cross section in the direction K. Fig. 8 illustrates an example in which the fixtures 72 are provided at four corner portions and the center of each side of the photovoltaic power generation sheet 4, and the number and installation positions of the fixtures 72 are not limited to the illustrated example, and for example, a plurality of fixtures 72 may be provided at equal intervals in the longitudinal direction X and the width direction Y of the photovoltaic power generation sheet 4.

In the fixture 73 illustrated in Fig. 17, the exposed portion 53 and the embedded portion 54 has a rectangular cross section in the direction K. Fig. 9 illustrates an example in which the plurality of fixtures 73 extending in the width direction Y of the photovoltaic power generation sheet 4 is provided at equal intervals in the longitudinal direction X of the photovoltaic power generation sheet 4, and the fixtures 73 extending in the longitudinal direction X of the photovoltaic power generation sheet 4 may be provided at equal intervals in the width direction Y of the photovoltaic power generation sheet 4.

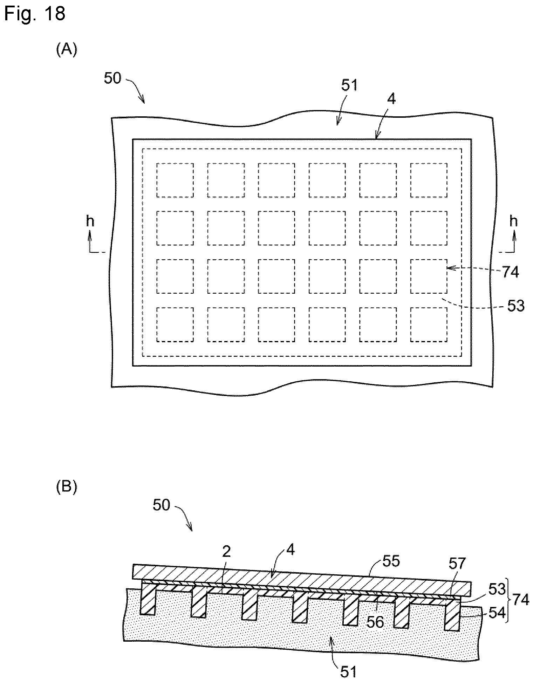

The fixture 74 illustrated in Fig. 18 includes an exposed portion 53 and a plurality of embedded portions 54 provided integrally with the exposed portion 53. The exposed portion 53 of the fixture 74 has a grid shape, and is bonded to the surface 56 of the photovoltaic power generation sheet 4 with the bonding layer 57 interposed therebetween. Each of the embedded portions 54 of the fixture 74 extends from an intersection of a grid of the exposed portion 53 and is embedded in the fixation target 51. Each of the embedded portions 54 has the same shape as the embedded portion 54 illustrated in Figs. 12(A), 12(B), 12(D), 12(E), 12(F), and 12(G) such as a columnar shape, and a plate shape.

The above modification examples exmaples include a case where the photovoltaic power generation sheet 4 is flexible. Here, the photovoltaic power generation sheet 4 may be a panel sheet that is hard and is not flexible like a conventional silicon-based panel sheet.

From the viewpoint of preventing breakage of surrounding objects by the fixtures 52,72,73, and 74 when the fixtures 52,72,73, and 74 scatter, the fixtures 52,72,73 and 74 may be formed using lightweight or porous metal, a material that is less likely to damage surrounding objects. The metal forming the fixtures 52,72, 73, and 74 can be appropriately selected according to the safety standard of the installation place. Since the fixtures 52,72, 73, and 74 can be reduced in size and thickness by selecting a metal, the weight and size of the fixture 52 can be reduced in some cases as compared with a case where the fixtures 52,72, 73, and 74 are manufactured by using resin alone.

In a case where the fixtures 52,72, 73, and 74 are formed using metal, the strength and weather resistance of the fixtures 52,72, 73, and 74 themselves can be improved.

As another means for improving the strength of the fixtures 52,72, 73, and 74, the materials of the fixtures 52,72, 73, and 74 may be composite reinforced materials containing reinforcing fibers in resin.

The material of the reinforced fibers contained in the composite reinforced material is not particularly limited, and examples thereof include glass fibers, carbon fibers, aramid fibers, and metal fibers. The content of the fibers is preferably 5% or more, more preferably 15% or more, and still more preferably 30% or more in the volume. Thus, the fixtures 52,72, 73, and 74 can have appropriate strength. On the other hand, by setting the content of the reinforcing fibers to 80% or less, more preferably 70% or less, and still more preferably 60% or less in the volume, moldability can be imparted. The average fiber length of the reinforcing fibers is preferably 100% or less, more preferably 75% or less, and more preferably 50% or less of the diameter of the exposed portion 53 (the maximum diameter in a case where the diameter of the exposed portion 53 changes in the extending direction J). The diameter of the exposed portion 53 refers to the diameter of the cross section when the cross section of the exposed portion 53 is circular, and refers to the diameter of a circumscribed circle of the cross section when the cross section of the exposed portion 53 is not circular.

In the installation structure described above, the fixtures 52,72, 73, and 74 extend perpendicularly to the installation surface 2 inclined at an angle of 1.5° or more with respect to the horizontal plane, or the surfaces of the exposed portions of the fixtures 52,72, 73, and 74 are inclined at an angle of 1.5° or more with respect to the horizontal plane, so that the surface 6 of the photovoltaic power generation sheet 4 installed on the installation surface 2 is inclined at an angle of 1.5° or more with respect to the horizontal plane.

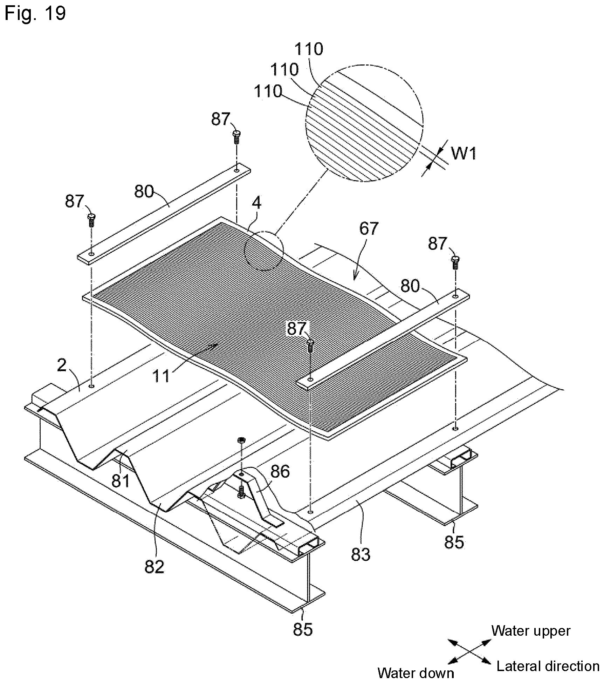

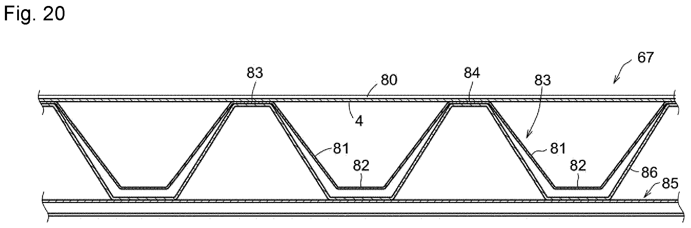

Further, the installation structure for the photovoltaic power generation sheet of the present invention can be modified as illustrated in Figs. 19 and 20. A installation structure 67 of the photovoltaic power generation sheet illustrated in Figs. 19 and 20 includes an installation surface 2, a photovoltaic power generation sheet 4 provided on an upper side of the installation surface 2, and an attachment member 80 for attaching the photovoltaic power generation sheet 4 to the installation surface 2. The photovoltaic power generation sheet 4 includes one or a plurality of power generators 11. As illustrated in Fig. 19, the power generator 11 is monolithic in a state where belt-shaped power generation cells 110 extending in one direction are arranged side by side in the width direction of the power generation cells 110. Hereinafter, the a structure monolithic may be referred to as a "monolithic structure".

The photovoltaic power generation sheet 4 is disposed in such a manner that the longitudinal direction of the power generation cell 110 intersects the direction in which water flows on the installation surface. Therefore, in the installation structure 67 of the photovoltaic power generation sheet 4, in a case where streaky dirt (sometimes referred to as "thread dirt" or the like) occurs on the photovoltaic power generation sheet 4, only a part of the entire length of the belt-shaped power generation cell 110 is covered with the thread dirt, so that it is possible to reduce the decrease in power generation efficiency in each power generation cell 110. As a result, according to the installation structure 67 of the photovoltaic power generation sheet 4 according to the present modification, stable power generation efficiency can be obtained.

In the present modification, the installation surface is a surface intersecting a horizontal plane. Hereinafter, the installation surface 2 will be described as a roof surface having a gradient. On the installation surface, a direction along the gradient is defined as a "water flow direction", and a direction intersecting the water flow direction is defined as a "lateral direction". In the present embodiment, the "lateral direction" is orthogonal to the water flow direction. A direction orthogonal to the water flow direction and the lateral direction is defined as a "up-and-down direction". In the water flow direction, a high side is defined as "water upper side", and a low side is defined as "water down side".

In addition, in the present modification, "plan view" refers to an object viewed in the up-and-down direction. In the present modification, "parallel" includes not only a case where two straight lines, sides, surfaces, and the like do not intersect even when extended, but also a case where an angle formed by the two straight lines, sides, surfaces, and the like intersects within a range of 10°. In addition, "orthogonal" includes a case where two straight lines, sides, surfaces, and the like intersect at 90° ± 10°.

In the present modification, as illustrated in Fig. 19, the photovoltaic power generation sheet 4 is formed in a rectangular shape in plan view. In the present modification, the longitudinal direction of the photovoltaic power generation sheet 4 is parallel to the water flow direction, and the shortitudinal direction thereof is parallel to the lateral direction. Here, the photovoltaic power generation sheet 4 may be installed such that the longitudinal direction is parallel to the lateral direction and the shortitudinal direction is parallel to the water flow direction. The shape of the photovoltaic power generation sheet 4 is not limited to the rectangular shape in plan view, and may be, for example, a square shape in plan view, a substantially circular shape in plan view, an elliptical shape in plan view, a polygonal shape in plan view, or the like.

In the power generator 11 having the monolithic structure, the plurality of power generation cells 110 are mechanically joined and electrically connected to each other. The power generation amount of one power generator 11 can be changed by increasing or decreasing the number of power generation cells 110.

Each power generation cell 110 extends in one direction and is formed in a belt shape. In the present modification, the longitudinal direction of the power generation cell 110 is parallel to the longitudinal direction of the photovoltaic power generation sheet 4. One power generation cell 110 extends from an end portion on one side (one end portion) to an end portion on the other side (the other end portion) of the photovoltaic power generation sheet 4 in the longitudinal direction. The maximum distance from the end surface of the back sheet 10 (Fig. 2(A)) to the end surface of the power generation cell 110 is preferably 1.0 mm or more and 500 mm or less, more preferably 2.0 mm or more and 300 mm or less, and still more preferably 3.0 mm or more and 100 mm or less. A case where the maximum distance from the end surface of the back sheet 10 to the end surface of the power generation cell 110 is 500 mm or less is referred to as the "end portion of the photovoltaic power generation sheet 4". In the present modification, as illustrated in Fig. 2(A), the sealant 13 is present between the end surface of the back sheet 10 and the end surface of the power generation cell 110, and the end surface of the power generation cell 110 may be flush with the end surface of the back sheet 10 and/or the end surface of the barrier sheet 12.

The width of the power generation cell 110 is preferably 0.003% or more and 1.0% or less, more preferably 0.01% or more and 0.3% or less, and still more preferably 0.03% or more and 0.15% or less with respect to the length of the power generation cell 110. Specifically, the width W1 (Fig. 2(C), Fig. 19) of the power generation cell 110 is preferably 1 mm or more and 10 mm or less, more preferably 1.5 mm or more and 7 mm or less, and still more preferably 2 mm or more and 5 mm or less. The width W1 of one power generation cell 110 refers to the maximum width of a portion that substantially receives light, and in the present embodiment, refers to the maximum width in the power generation layer 22 (hole transport layer 221, photoelectric conversion layer 222, and electron transport layer 223).

### Roof surface

A roof surface is an upper surface of a roof member, and is a surface of a roof in a building. The roof member is a uneven roof 83 in which a plurality of convex portions 81 and concave portions 82 extending in the water flow direction are repeatedly formed in the lateral direction.

As illustrated in Fig. 20, each of the convex portions 81 is formed in a shape (an inverted V shape in cross section) in which the width narrows toward a top portion 84 side. The top portion 84 of each of the convex portions 81 is formed in a substantially planar shape. The shape of each of the convex portions 81 does not necessarily have an inverted V-shaped cross section, and may have, for example, a rectangular cross section, a C-shaped cross section, or the like.

Each of the concave portions 82 is the lowest portion of the roof member in a cross-sectional view, and is positioned between adjacent convex portions 81. In the present modification, each of the concave portions 82 is formed in a substantially planar shape. Here, each of the concave portions 82 does not need to be a flat surface. For example, in a case where the uneven roof 83 is a corrugated slate, each of the concave portions 82 is formed in a curved surface shape protruding downward.

The uneven roof 83 according to the present modification is a folded plate roof. Here, the uneven roof 83 may be, for example, a slate roof, a roof deck, a shingled bar-laid roof, an upright flat roof, or the like.

As illustrated in Fig. 19, the roof member is attached to a cross member 85 via a plurality of tight frames 86. The cross member 85 is a horizontal member in a building, and is bridged between columns, for example. Examples of the cross member 85 include a beam (including girders, joists, and the like.), a beam, a purlin, and the like. The tight frames 86 are fixed to the upper surface of the cross member 85 and support the roof member. The plurality of tight frames 86 are arranged at intervals in the water flow direction. The arithmetic average roughness of the surface of the roof member is preferably 5 mm or less, more preferably 1 mm or less, and still more preferably 0.5 mm or less. On the other hand, the arithmetic average roughness of the surface of the roof member is preferably 100 nm or more, more preferably 10 µm or more, and still more preferably 100 µm or more. By setting the surface roughness to 5 mm or less, frictional force can be generated between the photovoltaic power generation sheet 4 and the installation surface 2, so that slippage in the surface direction can be suppressed and the fixing force can be improved. The arithmetic average roughness is measured in accordance with JIS B 0601.

### Installation structure 67

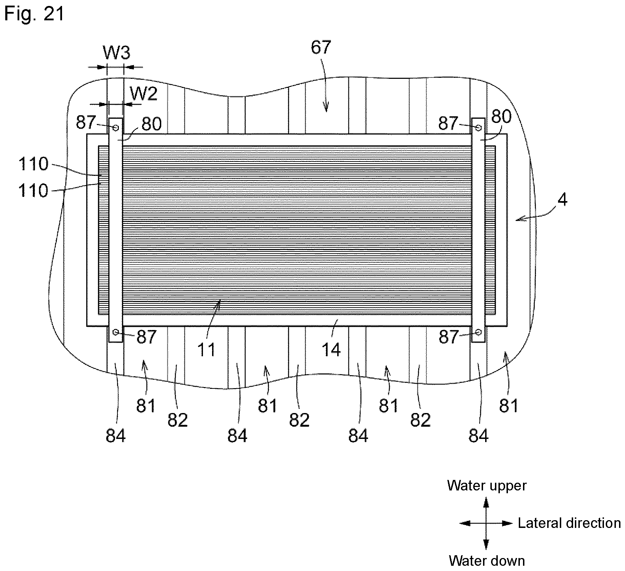

The photovoltaic power generation sheet 4 is attached to the roof surface in a planar shape. As illustrated in Fig. 20, the photovoltaic power generation sheet 4 is disposed across the top portions 84 of the plurality of convex portions 81, and is fixed by being pressed against the roof surface from above by the plurality of attachment members 80. In the present modification, as illustrated in Fig. 21, the photovoltaic power generation sheet 4 is disposed in such a manner that the longitudinal direction of the power generation cell 110 intersects the water flow direction.

The angle formed by the light receiving surface of the photovoltaic power generation sheet 4 (the surface of the photovoltaic power generation sheet 4) and the horizontal plane is 1.5° or more, more preferably 5.0° or more, and still more preferably 15.0° or more. As a result, even when streaky dirt occurs, streaky dirt having a narrow width can be obtained. Since the photovoltaic power generation sheet according to the present modification has substantially the same thickness over the entire length, the "angle formed by the light receiving surface of the photovoltaic power generation sheet and the horizontal plane" is synonymous with the "angle formed by the installation surface and the horizontal plane".

Each of the attachment members 80 is formed in an elongated shape extending in one direction. The attachment member 80 is fixed to the installation surface 2, and the photovoltaic power generation sheet 4 can be attached to the installation surface 2 by pressing the photovoltaic power generation sheet 4 from above. Each attachment member 80 is disposed in such a manner that the longitudinal direction thereof intersects the longitudinal direction of the power generation cell 110. In the present modification, the longitudinal direction of each attachment member 80 is orthogonal to the longitudinal direction of the power generation cell 110, that is, parallel to the water flow direction. As illustrated in Fig. 21, the attachment members 80 overlap the power generator 11 in a state where the photovoltaic power generation sheet 4 is pressed against the roof surface. As described above, in the present modification, even when attachment members 80 overlap the power generator 11, all portions of each power generation cell 110 are not covered by the attachment members 80. As a result, when the power generator 11 having a monolithic structure having the belt-shaped power generation cell 110 is attached to the installation surface 2 by the attachment members 80, it is possible to simplify the installation structure while suppressing a decrease in power generation efficiency.

The plurality of attachment members 80 is disposed at intervals in the lateral direction. It is preferable that the plurality of attachment members 80 press the end portion of the photovoltaic power generation sheet 4 in the longitudinal direction. As a result, it is possible to suppress flutter of the photovoltaic power generation sheet 4 due to the wind, to suppress a decrease in power generation efficiency, and to reduce breakage.

In the present modification, each of the attachment members 80 is formed in a flat plate shape. The width of each of the attachment members 80 is preferably constant in the longitudinal direction. The width of each of the attachment members 80 is preferably 2 mm or more and 50 mm or less, more preferably 3 mm or more and 40 mm or less, and still more preferably 5 mm or more and 35 mm or less. By setting the width of each of the attachment members 80 to 2 mm or more, bending of the power generator 11 can be suppressed, and breakage of the power generator 11 can be reduced. By setting the width of each of the attachment members 80 to 50 mm or less, the area can be reduced where the power generator 11 is covered by the attachment member 80, and the power generation efficiency can be increased.

On the contact surface of the flat plate of the attachment member 80, a corner portion (edge) in contact with the photovoltaic power generation sheet 4 is preferably subjected to C chamfering or R chamfering. As a result, when an external force is applied in the vertical direction from the installation surface 2 at the contact portion between the photovoltaic power generation sheet 4 and the attachment member 80 due to wind or the like, it is possible to suppress concentration of the force applied from the attachment member 80 to the photovoltaic power generation sheet 4, and it is possible to effectively suppress breakage of the photovoltaic power generation sheet 4. In particular, unlike a rigid photovoltaic power generator, it is difficult to predict the deformation of the photovoltaic power generation sheet 4 which is likely to be elastically deformed, and therefore, the photovoltaic power generation sheet 4 can be installed for a long period of time by dispersing a local force applied to the contact portion. A similar method is to provide a spacer of elastic member or the like between the photovoltaic power generation sheets 4. The elastic member is not particularly limited, and examples thereof include rubber, a soft resin, a metal washer, a torsion coil spring, and a leaf spring.

The thickness of the attachment member 80 is preferably thin. The thickness of the attachment member 80 is preferably 1 mm or more and 10 mm or less, more preferably 2 mm or more and 7 mm or less, and still more preferably 3 mm or more and 5 mm or less. Thus, the shadow of the attachment member 80 overlapping the power generator 11 can be reduced.

The attachment member 80 is formed to be longer than the length of the photovoltaic power generation sheet 4 in the shortitudinal direction. As illustrated in Fig. 19, the attachment member 80 is disposed such that the longitudinal direction of the attachment member 80 is in the water flow direction, and is attached to the upper surface of the top portion 84 of the convex portion 81 along the plurality of convex portions 81. In the attachment member 80, the portion protruding from the edge of the photovoltaic power generation sheet 4 is fixed to the installation surface 2 by the fixture 87, whereby the attachment member 80 is fixed to the installation surface 2. Examples of the fixture 87 include a bolt/nut, a screw, a rivet, a pin, a hook and loop fastener, a line fastener, and a double-sided tape. The fixing of the attachment member 80 to the roof surface is not limited to the fixture 87, and may be, for example, adhesion, welding, magnetic bonding, or the like.

The attachment member 80 is preferably formed in a flat plate shape. As a result, the contact area with respect to the photovoltaic power generation sheet 4 can be increased. An anti-slip sheet is preferably disposed on a contact surface of the attachment member 80 with respect to the photovoltaic power generation sheet 4.

However, the attachment member 80 is not limited to a flat plate shape, and may be formed in, for example, a rod shape having a rectangular cross section, a rod shape having a circular cross section, a pipe shape, or a semicircular cross section in which only the contact surface with the photovoltaic power generation sheet 4 is a flat surface. The attachment member 80 of the present modification is formed in a linear shape, but as long as the longitudinal direction of the attachment member 80 intersects the longitudinal direction of power generation cell 110, for example, a shape such as a V shape in plan view, a Y shape in plan view, a Z shape in plan view, and an S shape in plan view may be adopted.

The material of the attachment member 80 is not particularly limited, and examples thereof include metal, synthetic resin, carbon, rubber, cloth, leather, and the like. Examples of the metal include aluminum, SUS, and a coated metal member. Examples of the synthetic resin include thermoplastic resins, thermosetting resins, general-purpose plastics, composite reinforced materials (engineering plastics), and vinyl resins (for example, polyvinyl chloride). Specific examples of the synthetic resin include polypropylene, polyethylene, hard vinyl chloride, polycarbonate, polyamide, and PPS. Examples of the composite reinforced material include those containing the above-described synthetic resin, carbon, glass, and metal fibers.

The gap between the roof surface and the photovoltaic power generation sheet 4 is preferably as small as possible from the viewpoint of suppressing breakage and a decrease in power generation efficiency of the photovoltaic power generation sheet 4 by more effectively suppressing vibration of the photovoltaic power generation sheet 4. It is preferable that the gap between the photovoltaic power generation sheet 4 and one of the inclined surfaces of the concave portion 82 and the convex portion 81 is closed using a face door member or the like. In addition, a gap between the top portion 84 of the convex portion 81 and the photovoltaic power generation sheet 4 is preferably filled with a joint material. Examples of the joint material include a high-viscosity resin and cement. The viscosity of the joint material is preferably 0.1 Pa·s or more, more preferably 10 Pa·s or more. On the other hand, the viscosity of the joint material is preferably 10,000 Pa·s or less, and more preferably 1000 Pa·s or less. By setting the viscosity of the joint material to 0.1 Pa·s or more, the shape can be maintained not only in the surface direction but also in the vertical direction, so that the gap can be effectively prevented. In addition, by setting the viscosity of the joint material to 10,000 Pa · s or less, it is possible to easily spread the joint material when the joint material is applied to the installation surface 2 or the back surface of the photovoltaic power generation sheet 4 at the time of fixing the photovoltaic power generation sheet 4, and thus, it is possible to improve construction.

When the gap between the photovoltaic power generation sheet 4 and the installation surface 2 is closed, the effect of suppressing vibration by wind or the like can be sufficiently obtained even when only the peripheral portion of the photovoltaic power generation sheet 4 is closed. The term "peripheral portion" as used herein refers to a region up to a certain distance from the end portion toward the central portion of the photovoltaic power generation sheet 4 in the direction along the installation surface 2. The certain distance is preferably 5 mm or more, more preferably 100 mm or more, and still more preferably 150 mm or more. On the other hand, the certain distance is preferably 250 mm or less, more preferably 200 mm or less, and still more preferably 175 mm or less. By closing the gap between the photovoltaic power generation sheet 4 and the installation surface 2 in the peripheral portion, the vibration of the photovoltaic power generation sheet 4 can be appropriately suppressed, the joint material can be efficiently used, and the weight load on the installation surface 2 and the like can be reduced, so that the photovoltaic power generation sheet 4 can be installed with respect to the installation surface such as a fragile roof.

In a case where only the peripheral portion of the photovoltaic power generation sheet 4 is closed, a cavity closed to the outside with relatively high airtightness is generated between the photovoltaic power generation sheet 4 and the installation surface 2. Therefore, the air in the cavity expands and contracts due to a temperature change, which may generate stress in a direction perpendicular to the photovoltaic power generation sheet 4, and may cause breakage of the photovoltaic power generation sheet 4.

In order to suppress this phenomenon, the photovoltaic power generation sheet 4 can be more stably installed by making the joint material porous or providing an air hole in the joint material. The total passage cross-sectional area of the air hole is preferably 20mm² or more, more preferably 25mm² or more, and still more preferably 50mm² or more. On the other hand, the total passage cross-sectional area of the air hole is preferably 200mm² or less, more preferably 150mm² or less, and still more preferably 100mm² or less. By setting the air hole in such a manner that the total passage cross-sectional area is 20mm² or more, the air expanded and contracted by the temperature change and the external air can be appropriately exchanged, and the stress generated in the photovoltaic power generation sheet 4 can be reduced. In addition, by setting the air hole in such a manner that the total passage cross-sectional area is 200mm² or less, rainwater can be suppressed from entering, and deterioration of the photovoltaic power generation sheet 4 due to rainwater can be suppressed. From the viewpoint of waterproofing, the air hole is preferably provided on the lower side in the gradient direction of the installation surface 2, and more preferably faces the lower side in the gradient direction of the installation surface 2.

In a case where the gap between the outer peripheral portion of the photovoltaic power generation sheet 4 and the installation surface 2 is large and embedding with the joint material is difficult, for example, a lid member such as hard resin, metal, or ceramic may be provided at the end portion.

### Effects

As described above, in the installation structure 67 of the photovoltaic power generation sheet 4 according to the present modification, the photovoltaic power generation sheet 4 is installed on the installation surface 2 in such a manner that the longitudinal direction of the power generation cell 110 intersects the water flow direction. Therefore, even when streaky dirt occurs on the light receiving surface of the photovoltaic power generation sheet 4, all the portions of each power generation cell 110 are not covered with the streaky dirt. Therefore, the photovoltaic power generation sheet 4 including the power generator 11 having the belt-shaped power generation cell 110 can be installed while suppressing a decrease in power generation efficiency. In particular, a solar cell using an organic compound such as a perovskite compound has a property that a decrease in power generation efficiency is limited even when a part of the power generation cell 110 in the longitudinal direction is covered, as compared with a solar cell using an inorganic compound. Therefore, according to the installation structure 67 of the photovoltaic power generation sheet 4 according to the present modification, it is possible to further suppress a decrease in power generation efficiency when the photovoltaic power generation sheet 4 is attached to the installation surface 2 having a gradient.

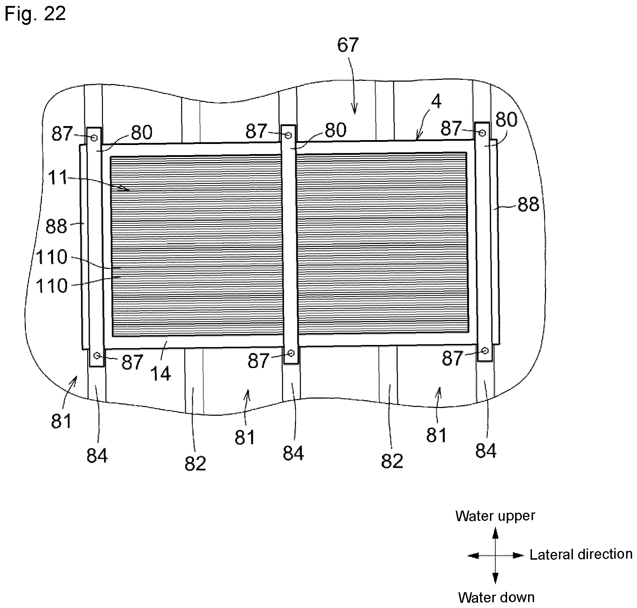

In the above modification, the photovoltaic power generation sheet 4 is attached by the two attachment members 80. However, as illustrated in Fig. 22, the photovoltaic power generation sheet 4 may be pressed at three or more positions of the two attachment members 80 that press both end portions of the photovoltaic power generation sheet 4 in the longitudinal direction and the attachment member therebetween. Further, the attachment member 80 may press a region 88 where the power generator 11 does not exist with respect to the installation surface 2 in the photovoltaic power generation sheet 4. Here, the attachment member 80 that presses the intermediate portion of the photovoltaic power generation sheet 4 in the longitudinal direction overlaps the power generator 11. However, it is preferable, in a case where the power generator 11 is divided into two or more sections, to press the region between adjacent power generators 11 with the attachment member 80.

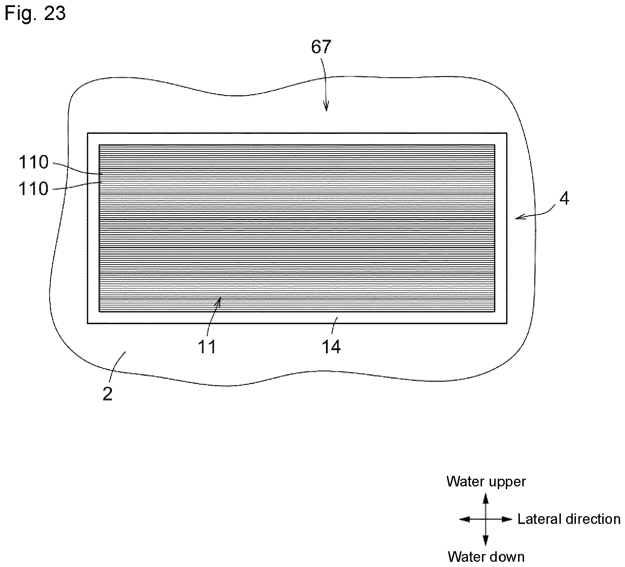

As illustrated in Fig. 23, the attachment member 80 may not be provided in attaching the photovoltaic power generation sheet 4. The photovoltaic power generation sheet 4 may be fixed to the installation surface 2 with a hook-and-loop fastener, a magnet, a double-sided tape, a bonder, a screw tool, a pin, a rivet, or the like. For example, in a case of fixing with a magnet, one magnet may be fixed to the back surface of the photovoltaic power generation sheet 4 using a bonder, an adhesive, a double-sided tape, or the like, and the other magnet may be fixed to the installation surface 2 using a bonder, an adhesive, a double-sided tape, or the like. Note that in a case where the installation surface 2 has magnetism, a magnet that attracts the installation surface 2 may be fixed only to the photovoltaic power generation sheet 4 using a bonder, an adhesive, a double-sided tape, or the like. Specific examples of the magnet may include a neodymium magnet tape (NMS-3-200) manufactured by Sugatsune Kogyo Co., Ltd.

Note that in the above modification, the roof surface is cited as an example of the installation surface 2, and the installation surface 2 is not limited to the roof surface. When a bonder is used, it is preferable to select the bonder according to the location of the installation surface 2. For example, in an environment of an acidic atmosphere such as a water treatment plant, an acid-resistant bonder is preferably used. In addition, for example, in a coastal environment, a bonder having durability against salt damage is preferably used. In addition, for example, in a high-temperature and high-humidity environment, a bonder having moisture and heat resistance is preferably used.

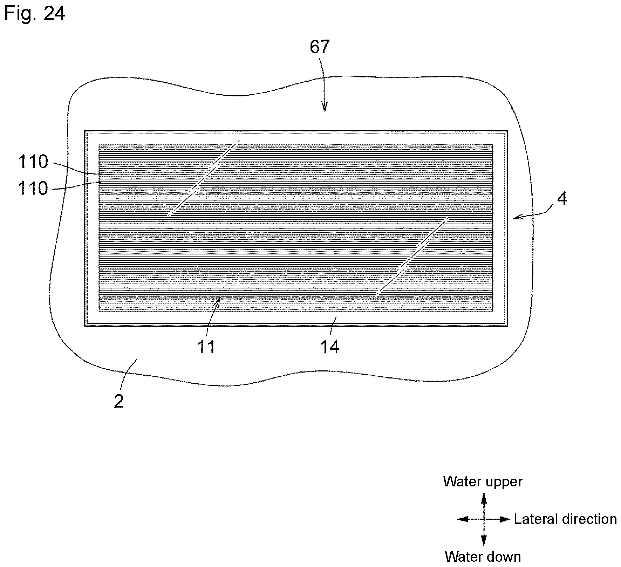

As illustrated in Fig. 24, as long as the longitudinal direction of the power generation cell 110 of the photovoltaic power generation sheet 4 intersects the water flow direction, the entire light receiving surface of the photovoltaic power generation sheet 4 may be attached in such a manner that the entire surface is covered with a case or the like that is translucent. In this case, the photovoltaic power generation sheet 4 is fixed to the installation surface 2 via the case. The material of the case and the like is not particularly limited, and examples thereof include hard resin, ceramic, glass, and the like, and may be soft resin. The outer surface of the light transmission plate covering the light receiving surface of the photovoltaic power generation sheet 4 in the case may be subjected to surface treatment/processing within a range not impairing the translucency from the viewpoint of stain prevention and reflection prevention. In a case where the light transmission plate is detachably provided with respect to the photovoltaic power generation sheet 4, when significant dirt occurs on the light transmission plate, it is possible to more effectively suppress a decrease in efficiency due to dirt by replacing only the light transmission plate.

Further, in a roof member-integrated photovoltaic power generation module in which the roof member body and the photovoltaic power generation sheet 4 are integrated, the longitudinal direction of the power generation cell 110 may intersect the water flow direction.

In the above modification, the photovoltaic power generation sheet 4 is installed to have a planar shape along a virtual plane including the top portion 84 of the convex portion 81 of the uneven roof 83. However, the photovoltaic power generation sheet 4 may also be installed in a state of being curved in a waveform along the convex portion 81 and the concave portion 82. In this case, sand, dirt, and the like are likely to accumulate on a portion corresponding to the concave portion 82, and only the portion corresponding to the concave portion 82 is likely to be covered with dirt and the like. However, according to the installation structure 67 of the photovoltaic power generation sheet 4 of this aspect, since the longitudinal direction of the power generation cells 110 intersects with the water flow direction, each power generation cell 110 is not entirely covered over the entire length, and a decrease in power generation efficiency can be reduced. When the photovoltaic power generation sheet 4 is attached in a state of being curved in a waveform along the concave portion 82 and the convex portion 81 of the uneven roof 83, the power generator 11 may not be provided at a position corresponding to the concave portion 82.

In a case of the photovoltaic power generation sheet 4 having the photoelectric conversion layer 222 containing a perovskite compound, the power generator 11 is not limited to a rectangular shape, and can be easily designed. By taking advantage of this characteristic, the shape of the photovoltaic power generation sheet 4 can be adapted to the shape of the installation surface 2. In the above modification, the photovoltaic power generation sheet 4 has a rectangular shape in plan view, and for example, in a case where the installation surface 2 has a fan shape in plan view, the photovoltaic power generation sheet 4 may also be formed in a fan shape in plan view. In this case, the longitudinal direction of the attachment member 80 may intersect the longitudinal direction of the power generation cell 110. The shape of the photovoltaic power generation sheet 4 is not limited to a fan shape, and examples thereof include a circular shape, an elliptical shape, and a polygonal shape.

The shortest distance between the end portion of the photovoltaic power generation sheet 4 and the power generator 11 is preferably 50 mm or less, more preferably 35 mm or less, and still more preferably 25 mm or less. In this manner, the power generation efficiency can be improved by making the area of the power generator 11 as large as possible. In addition, by setting the shortest distance between the end portion of the photovoltaic power generation sheet 4 and the power generator 11 to 5 mm or more, more preferably 10 mm or more, and still more preferably 15 mm or more, the water resistance when the photovoltaic power generation sheet 4 is used outdoors can be improved.

A rod-shaped core member may be attached to the end portion of the photovoltaic power generation sheet 4. The rod-shaped core member is preferably fixed to the end portion of the photovoltaic power generation sheet 4 in such a manner that the central axis thereof is parallel to the shortitudinal direction of the photovoltaic power generation sheet 4. When the rod-shaped core member is rotated around the central axis, the photovoltaic power generation sheet 4 is wound around the rod-shaped core member. Therefore, the photovoltaic power generation sheet 4 is not a sheet shape but a rod shape at the time of transportation, and the transportability can be improved. Further, by winding the photovoltaic power generation sheet 4 around the rod-shaped core member even after installation, the photovoltaic power generation sheet 4 can be temporarily removed from the installation surface 2 in an easy manner, and reinstallation can be facilitated. As a result, the photovoltaic power generation sheet 4 can be temporarily removed and stored in a bad weather such as a storm. The shape of the rod-shaped core member is not particularly limited as long as the rod-shaped core member can be wound with the photovoltaic power generation sheet 4, and the rod-shaped core member may be either hollow or solid, and the cross-sectional shape may be circular or polygonal. In addition, a handle may be provided on the rod-shaped core member, and the rod-shaped core member may be rotated by the handle. In addition, the power of the motor may be transmitted to the rod-shaped core member, and the rod-shaped core member may be rotated by the motor.

The winding diameter of the rod-shaped core member is preferably 5 cm or more, more preferably 7.5 cm or more, and still more preferably 10 cm or more. On the other hand, the winding diameter of the rod-shaped core member is preferably 30 cm or less, more preferably 20 cm or less, and still more preferably 15 cm or less. By setting the winding diameter of the rod-shaped core member to 5 cm or more, breakage of the photovoltaic power generation sheet 4 can be suppressed. By setting the winding diameter of the rod-shaped core member to 30 cm or less, transportation and construction can be easily performed.

In the modification described above, the back sheet 10 of the photovoltaic power generation sheet 4 is directly fixed to the installation surface 2, and another sheet member may be interposed between the back sheet 10 and the installation surface 2. Examples of the sheet member include a synthetic resin sheet, a fiber-reinforced resin sheet, and an elastic sheet such as rubber. Thus, the photovoltaic power generation sheet 4 can be prevented from being displaced.

The sheet member is detachably attached to the installation surface 2. Thus, the photovoltaic power generation sheet 4 is detachably fixed to the installation surface 2. As a fixing structure between the sheet member and the installation surface 2, at least one selected from the group consisting of a hook-and-loop fastener, a magnet, a double-sided tape, a bonder, a flange member, a sandwiching member, a hanging member, and a frame member described above is used.

The installation surface 2 is not limited to the roof surface, and can be applied to, for example, a wall member (metal-based siding material, ceramic-based siding material, sandwich panel, and the like), a partition, a door member, a fence member, and the like. In this case, the vertical direction (direction from top to bottom) is the water flow direction.

In the above modification, the photovoltaic power generation sheet 4 having the photoelectric conversion layer 222 containing the perovskite compound has been described as an example, and in the present invention, a photovoltaic power generation sheet 4 can exhibit the same effect, as long as the photovoltaic power generation sheet 4 is flexible. Further, the photovoltaic power generation sheet 4 according to the present invention may be not only a solar cell capable of obtaining a power generation effect by light, but also a sheet (light energy conversion sheet) that converts light energy into another energy. Examples of the light energy conversion sheet include, in addition to the photovoltaic power generation sheet 4, a light heating sheet (photovoltaic power-driven thermoelectric conversion device) that converts light energy into thermal energy.

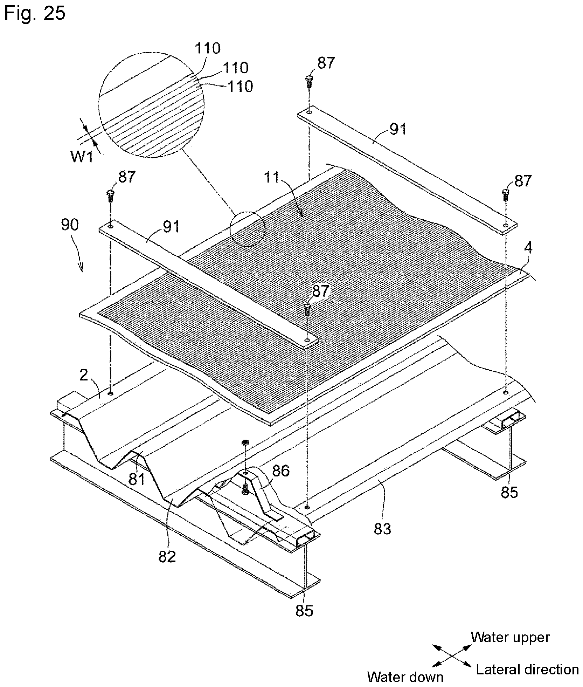

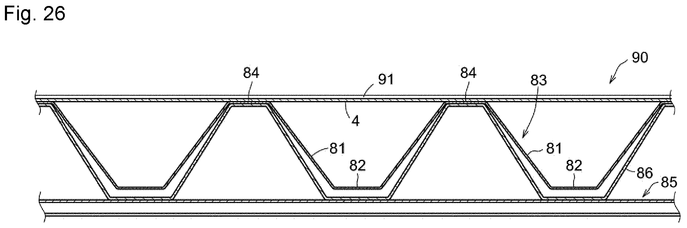

Further, the installation structure for the photovoltaic power generation sheet of the present invention can be modified as illustrated in Figs. 25 and 26. A installation structure 90 of the photovoltaic power generation sheet illustrated in Figs. 25 and 26 includes an installation surface 2, a photovoltaic power generation sheet 4 provided on an upper side of the installation surface 2, and an attachment member 91 for attaching the photovoltaic power generation sheet 4 to the installation surface 2. The photovoltaic power generation sheet 4 is a sheet material that generates power by receiving sunlight. The photovoltaic power generation sheet 4 includes one or a plurality of power generators 11. As illustrated in Fig. 25, the power generator 11 is monolithic in a state where belt-shaped power generation cells 110 extending in one direction are arranged side by side in the width direction of the power generation cells 110. Hereinafter, the a structure monolithic may be referred to as a "monolithic structure".

Each of the attachment member 91 is formed in an elongated shape extending in one direction. The attachment member 91 is fixed to the installation surface 2, and the photovoltaic power generation sheet 4 can be attached to the installation surface 2 by pressing the photovoltaic power generation sheet 4 from above. Under a state where the photovoltaic power generation sheet 4 and the attachment member 91 are attached to the installation surface 2, the longitudinal direction of the attachment member 91 intersects the longitudinal direction of the power generation cell 110 of the photovoltaic power generation sheet 4.

In the installation structure 90 of the photovoltaic power generation sheet 4 configured as described above, only a part of the entire length of the belt-shaped power generation cell 110 is covered with the attachment member 91, and thus, it is possible to reduce a decrease in power generation efficiency in each power generation cell 110. Moreover, since the photovoltaic power generation sheet 4 can be pressed by the long attachment member 91, flutter can be suppressed. Further, since the photovoltaic power generation sheet 4 is installed by being pressed from above by the attachment member 91 without being bonded to the installation surface 2, it is also possible to reduce bending when being detached from the installation surface. As a result, according to the installation structure 90 of the photovoltaic power generation sheet 4 according to the present modification, stable power generation efficiency can be obtained.

In the present modification, the installation surface 2 will be described as a roof surface having a gradient. On the roof surface, a direction along the gradient is defined as a "water flow direction", and a direction intersecting the water flow direction is defined as a "lateral direction". In the present modification, the "lateral direction" is orthogonal to the water flow direction. A direction orthogonal to the water flow direction and the lateral direction is defined as a "up-and-down direction". In the water flow direction, a high side is defined as "water upper side", and a low side is defined as "water down side".

Hereinafter, details of the installation structure 90 of the photovoltaic power generation sheet 4 according to the present modification will be described in detail with reference to the drawings.

As illustrated in Fig. 25, the photovoltaic power generation sheet 4 according to the present modification is formed in a rectangular shape in plan view. In the present modification, the longitudinal direction of the photovoltaic power generation sheet 4 is parallel to the water flow direction, and the shortitudinal direction thereof is parallel to the lateral direction. Here, the photovoltaic power generation sheet 4 may be installed such that the longitudinal direction is parallel to the lateral direction and the shortitudinal direction is parallel to the water flow direction. The shape of the photovoltaic power generation sheet 4 is not limited to the rectangular shape in plan view, and may be, for example, a square shape in plan view, a substantially circular shape in plan view, an elliptical shape in plan view, a polygonal shape in plan view, or the like.

### Power generator 11

The power generator 11 may be provided only one for each photovoltaic power generation sheet 4, or the power generator 11 may be sectioned in a plurality of locations. In one power generator 11, a plurality of power generation cells 110 are aligned and monolithic in one of the surface directions of the photovoltaic power generation sheet 4 (in Fig. 25, in the lateral direction, and in Fig. 2(A), in the front direction from the back of the paper). That is, the power generator 11 according to the present modification has a monolithic structure in which a plurality of power generation cells 110 constitute one module.

In the power generator 11 having the monolithic structure, the plurality of power generation cells 110 are mechanically joined and electrically connected to each other. The power generation amount of one power generator 11 can be changed by increasing or decreasing the number of power generation cells 110.

Each power generation cell 110 extends in one direction and is formed in a belt shape. In the present modification, the longitudinal direction of the power generation cell 110 is parallel to the longitudinal direction of the photovoltaic power generation sheet 4. One power generation cell 110 extends from an end portion on one side (one end portion) to an end portion on the other side (the other end portion) of the photovoltaic power generation sheet 4 in the longitudinal direction. The maximum distance from the end surface of the back sheet 10 (FIG. 2 (A)) to the end surface of the power generation cell 110 is preferably 1.0 mm or more and 500 mm or less, more preferably 2.0 mm or more and 300 mm or less, and still more preferably 3.0 mm or more and 100 mm or less. A case where the maximum distance from the end surface of the back sheet 10 to the end surface of the power generation cell 110 is 500 mm or less is referred to as the "end portion of the photovoltaic power generation sheet 4". In the present modification, as illustrated in Fig. 2(A), the sealant 13 is present between the end surface of the back sheet 10 and the end surface of the power generation cell 110, and the end surface of the power generation cell 110 may be flush with the end surface of the back sheet 10 and/or the end surface of the barrier sheet 12.

The width of the power generation cell 110 is preferably 0.003% or more and 1.0% or less, more preferably 0.01% or more and 0.3% or less, and still more preferably 0.03% or more and 0.15% or less with respect to the length of the power generation cell 110. Specifically, the width of the power generation cell 110 is preferably 1 mm or more and 10 mm or less, more preferably 1.5 mm or more and 7 mm or less, and still more preferably 2 mm or more and 5 mm or less.

### Roof surface

A roof surface is an upper surface of a roof member, and is a surface of a roof in a building. The roof member is an uneven roof 83 in which a plurality of convex portions 81 and concave portions 82 extending in the water flow direction are repeatedly formed at intervals in the lateral direction, and has the same structure as the roof member illustrated in Figs. 19 and 20.

That is, as illustrated in Fig. 26, each of the convex portions 81 is formed in a shape (an inverted V shape in cross section) in which the width narrows toward the top portion 84 side. The top portion 84 of each of the convex portions 81 is formed in a substantially planar shape. The shape of each of the convex portions 81 does not necessarily have an inverted V-shaped cross section, and may have, for example, a rectangular cross section, a C-shaped cross section, or the like.

Each of the concave portions 82 is the lowest portion of the roof member in a cross-sectional view, and is positioned between adjacent convex portions 81. In the present embodiment, each of the concave portions 82 is formed in a substantially planar shape. Here, each of the concave portions 82 does not need to be a flat surface. For example, in a case where the uneven roof 83 is a corrugated slate, each of the concave portions 82 is formed in a curved surface shape protruding downward.

The uneven roof 83 according to the present embodiment is a folded plate roof. Here, the uneven roof 83 may be, for example, a slate roof, a roof deck, a shingled bar-laid roof, an upright flat roof, or the like.

As illustrated in Fig. 25, the roof member is attached to a cross member 85 via a plurality of tight frames 86. The cross member 85 is a horizontal member in a building, and is bridged between columns, for example. Examples of the cross member 85 include a beam (including girders, joists, and the like.), a beam, a purlin, and the like. The tight frames 86 are fixed to the upper surface of the cross member 85 and support the roof member. The plurality of tight frames 86 are arranged at intervals in the water flow direction.

The arithmetic average roughness of the surface of the roof member is preferably 5 mm or less, more preferably 1 mm or less, and still more preferably 0.5 mm or less. On the other hand, the arithmetic average roughness of the surface of the roof member is preferably 100 nm or more, more preferably 10 µm or more, and still more preferably 100 µm or more. By setting the surface roughness to 5 mm or less, frictional force can be generated between the photovoltaic power generation sheet 4 and the installation surface 2, so that slippage in the surface direction can be suppressed and the fixing force can be improved. The arithmetic average roughness is measured in accordance with JIS B 0601.

### Installation structure 90

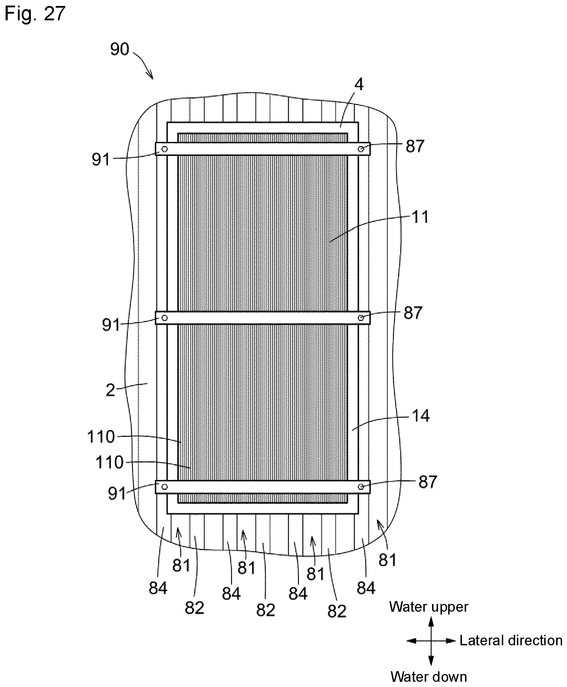

The photovoltaic power generation sheet 4 is attached to the roof surface in a planar shape. As illustrated in Fig. 26, the photovoltaic power generation sheet 4 is disposed across the top portions 84 of the plurality of convex portions 81, and is fixed by being pressed against the roof surface from above by the plurality of attachment members 91. In the present modification, as illustrated in Fig. 27, the photovoltaic power generation sheet 4 is disposed in such a manner that the longitudinal direction of the power generation cell 110 is parallel to the water flow direction. The photovoltaic power generation sheet 4 is disposed in such a manner that the surface of the photovoltaic power generation sheet 4 includes a surface inclined at an angle of 1.5° or more with respect to the horizontal plane.

Each attachment member 91 is disposed in such a manner that the longitudinal direction thereof intersects the longitudinal direction of the power generation cell 110. In the present modification, the longitudinal direction of each attachment member 91 is orthogonal to the longitudinal direction of the power generation cell 110, that is, parallel to the lateral direction. As illustrated in Fig. 27, the attachment members 91 overlap the power generator 11 in a state where the photovoltaic power generation sheet 4 is pressed against the roof surface. As described above, in the present modification, even when attachment members 91 overlap the power generator 11, all portions of each power generation cell 110 are not covered by the attachment members 91. As a result, when the power generator 11 having a monolithic structure having the belt-shaped power generation cell 110 is attached to the installation surface 2 by the attachment members 91, it is possible to simplify the installation structure while suppressing a decrease in power generation efficiency.

The plurality of attachment members 91 is disposed at intervals in the water flow direction. It is preferable that two of the plurality of attachment members 91 press an end portion of the photovoltaic power generation sheet 4 in the longitudinal direction. Further, the other attachment members 91 among the plurality of attachment members 91 are preferably disposed between the attachment members 91 which press the end portion of the photovoltaic power generation sheet 4. As a result, it is possible to suppress flutter of the photovoltaic power generation sheet 4 due to the wind, to suppress a decrease in power generation efficiency, and to reduce breakage.

Each of the attachment member 91 is formed in an elongated shape extending in one direction. In the present modification, each of the attachment members 91 is formed in a flat plate shape. The width of each of the attachment members 91 is preferably constant in the longitudinal direction. The width of each of the attachment members 91 is preferably 2 mm or more and 50 mm or less, more preferably 3 mm or more and 40 mm or less, and still more preferably 5 mm or more and 35 mm or less. By setting the width of each of the attachment members 91 to 2 mm or more, bending of the power generator 11 can be suppressed, and breakage of the power generator 11 can be reduced. By setting the width of each of the attachment members 91 to 50 mm or less, the area can be reduced where the power generator 11 is covered by the attachment member 91, and the power generation efficiency can be increased.

The thickness of the attachment member 91 is preferably thin. The thickness of the attachment member 91 is preferably 1 mm or more and 20 mm or less, more preferably 2 mm or more and 15 mm or less, and still more preferably 3 mm or more and 10 mm or less. Thus, the shadow of the attachment member 91 overlapping the power generator 11 can be reduced.

The attachment member 91 is formed to be longer than the length of the photovoltaic power generation sheet 4 in the shortitudinal direction. As illustrated in Fig. 25, the attachment member 91 is disposed in such a manner that the longitudinal direction of the attachment member 91 is in the lateral direction, and the attachment member 91 is attached to the upper surfaces of the top portions 84 of the plurality of convex portions 81 in such a manner that the attachment member 91 is across the plurality of convex portions 81. In the attachment member 91, the portion protruding from the edge of the photovoltaic power generation sheet 4 is fixed to the installation surface 2 by the fixture 87, whereby the attachment member 91 is fixed to the installation surface 2. Examples of the fixture 87 include a bolt/nut, a screw, a rivet, a pin, a hook and loop fastener, a line fastener, and a double-sided tape. The fixing of the attachment member 91 to the roof surface is not limited to the fixture 87, and may be, for example, adhesion, welding, magnetic bonding, or the like.

The attachment member 91 is preferably formed in a flat plate shape. As a result, the contact area with respect to the photovoltaic power generation sheet 4 can be increased. An anti-slip sheet is preferably disposed on a contact surface of the attachment member 91 with respect to the photovoltaic power generation sheet 4.

On the contact surface of the flat plate of the attachment member 91, a corner portion (edge) in contact with the photovoltaic power generation sheet 4 is preferably subjected to C chamfering or R chamfering. As a result, when an external force is applied in the vertical direction from the installation surface 2 at the contact portion between the photovoltaic power generation sheet 4 and the attachment member 91 due to wind or the like, it is possible to suppress concentration of the force applied from the attachment member 91 to the photovoltaic power generation sheet 4, and it is possible to effectively suppress breakage of the photovoltaic power generation sheet 4. In particular, unlike a rigid photovoltaic power generator, it is difficult to predict the deformation of the photovoltaic power generation sheet 4 which is likely to be elastically deformed, and therefore, the photovoltaic power generation sheet 4 can be installed for a long period of time by dispersing a local force applied to the contact portion. A similar method is to provide a spacer of elastic member or the like between the photovoltaic power generation sheets 4. The elastic member is not particularly limited, and examples thereof include rubber, a soft resin, a metal washer, a torsion coil spring, and a leaf spring.

However, the attachment member 91 is not limited to a flat plate shape, and may be formed in, for example, a rod shape having a rectangular cross section, a rod shape having a circular cross section, a pipe shape, or a semicircular cross section in which only the contact surface with the photovoltaic power generation sheet 4 is a flat surface. The attachment member 91 of the present modification is formed in a linear shape, but as long as the longitudinal direction of the attachment member 91 intersects the longitudinal direction of power generation cell 110, for example, a shape such as a V shape in plan view, a Y shape in plan view, a Z shape in plan view, and an S shape in plan view may be adopted.

The material of the attachment member 91 is not particularly limited, and examples thereof include metal, synthetic resin, carbon, rubber, cloth, leather, and the like. Examples of the metal include aluminum, SUS, and a coated metal member. Examples of the synthetic resin include thermoplastic resins, thermosetting resins, general-purpose plastics, composite reinforced materials (engineering plastics), and vinyl resins (for example, polyvinyl chloride). Specific examples of the synthetic resin include polypropylene, polyethylene, hard vinyl chloride, polycarbonate, polyamide, and PPS. Examples of the composite reinforced material include those containing the above-described synthetic resin, carbon, glass, and metal fibers.

The gap between the roof surface and the photovoltaic power generation sheet 4 is preferably as small as possible from the viewpoint of more effectively suppressing the vibration of the photovoltaic power generation sheet 4. It is preferable that the gap between the photovoltaic power generation sheet 4 and one of the inclined surfaces of the concave portion 82 and the convex portion 81 is closed using a face door member or the like. In addition, a gap between the top portion 84 of the convex portion 81 and the photovoltaic power generation sheet 4 is preferably filled with a joint material. Examples of the joint material include a high-viscosity resin and cement. The viscosity of the joint material is preferably 0.1 Pa·s or more, more preferably 10 Pa·s or more. On the other hand, the viscosity of the joint material is preferably 10,000 Pa·s or less, and more preferably 1000 Pa·s or less. By setting the viscosity of the joint material to 0.1 Pa·s or more, the shape can be maintained not only in the surface direction but also in the vertical direction, so that the gap can be effectively prevented. In addition, by setting the viscosity of the joint material to 10,000 Pa·s or less, it is possible to easily spread the joint material when the joint material is applied to the installation surface 2 or the back surface of the photovoltaic power generation sheet 4 at the time of fixing the photovoltaic power generation sheet 4, and thus, it is possible to improve construction.

When the gap between the photovoltaic power generation sheet 4 and the installation surface 2 is closed, the effect of suppressing vibration by wind or the like can be sufficiently obtained even when only the peripheral portion of the photovoltaic power generation sheet 4 is closed. The term "peripheral portion" as used herein refers to a region up to a certain distance from the end portion toward the central portion of the photovoltaic power generation sheet 4 in the direction along the installation surface 2. The certain distance is preferably 5 mm or more, more preferably 100 mm or more, and still more preferably 150 mm or more. On the other hand, the certain distance is preferably 250 mm or less, more preferably 200 mm or less, and still more preferably 175 mm or less. By closing the gap between the photovoltaic power generation sheet 4 and the installation surface 2 in the peripheral portion, the vibration of the photovoltaic power generation sheet 4 can be appropriately suppressed, the joint material can be efficiently used, and the weight load on the installation surface 2 and the like can be reduced, so that the photovoltaic power generation sheet 4 can be installed with respect to the installation surface such as a fragile roof.

In a case where only the peripheral portion of the photovoltaic power generation sheet 4 is closed, a cavity closed to the outside with relatively high airtightness is generated between the photovoltaic power generation sheet 4 and the installation surface 2. Therefore, the air in the cavity expands and contracts due to a temperature change, which may generate stress in a direction perpendicular to the photovoltaic power generation sheet 4, and may cause breakage of the photovoltaic power generation sheet 4.

In order to suppress this phenomenon, the photovoltaic power generation sheet 4 can be more stably installed by making the joint material porous or providing an air hole in the joint material. The total passage cross-sectional area of the air hole is preferably 20mm² or more, more preferably 25mm² or more, and still more preferably 50mm² or more. On the other hand, the total passage cross-sectional area of the air hole is preferably 200mm² or less, more preferably 150mm² or less, and still more preferably 100mm² or less. By setting the air hole in such a manner that the total passage cross-sectional area is 20mm² or more, the air expanded and contracted by the temperature change and the external air can be appropriately exchanged, and the stress generated in the photovoltaic power generation sheet 4 can be reduced. In addition, by setting the air hole in such a manner that the total passage cross-sectional area is 200mm² or less, rainwater can be suppressed from entering, and deterioration of the photovoltaic power generation sheet 4 due to rainwater can be suppressed. From the viewpoint of waterproofing, the air hole is preferably provided on the lower side in the gradient direction of the installation surface 2, and more preferably faces the lower side in the gradient direction of the installation surface 2.

In a case where the gap between the outer peripheral portion of the photovoltaic power generation sheet 4 and the installation surface 2 is large and embedding with the joint material is difficult, for example, a lid member such as hard resin, metal, or ceramic may be provided at the end portion.

### Effects

As described above, in the installation structure 90 of the photovoltaic power generation sheet 4 according to the present modification, the long attachment member 91 overlaps the power generator 11, and the longitudinal direction of the attachment member 91 intersects the longitudinal direction of the power generation cell 110. Therefore, even when the attachment member 91 overlaps the power generator 11, all portions of each power generation cell 110 are not covered by the attachment member 91. Therefore, when the photovoltaic power generation sheet 4 including the power generator 11 having the belt-shaped power generation cell 110 is attached to the installation surface 2 by the attachment member 91, a simplified installation structure 90 can be realized while suppressing a decrease in power generation efficiency. In particular, a solar cell using an organic compound such as a perovskite compound has a property that a decrease in power generation efficiency is limited even when a part of the power generation cell 110 in the longitudinal direction is covered, as compared with a solar cell using an inorganic compound. Therefore, according to the installation structure 90 of the photovoltaic power generation sheet 4 according to the present modification, it is possible to further suppress a decrease in power generation efficiency when the photovoltaic power generation sheet 4 is attached to the installation surface 2 by the attachment member 91.

In addition, the installation surface 2 is a roof surface having a gradient. The photovoltaic power generation sheet 4 is disposed in such a manner that the longitudinal direction of the power generation cell 110 is in the water flow direction of the roof surface. Therefore, when the photovoltaic power generation sheet 4 is carried to the roof surface in a state of being wound in the longitudinal direction and installed on the roof surface, the photovoltaic power generation sheet 4 can be expanded along the gradient, and workability is excellent.

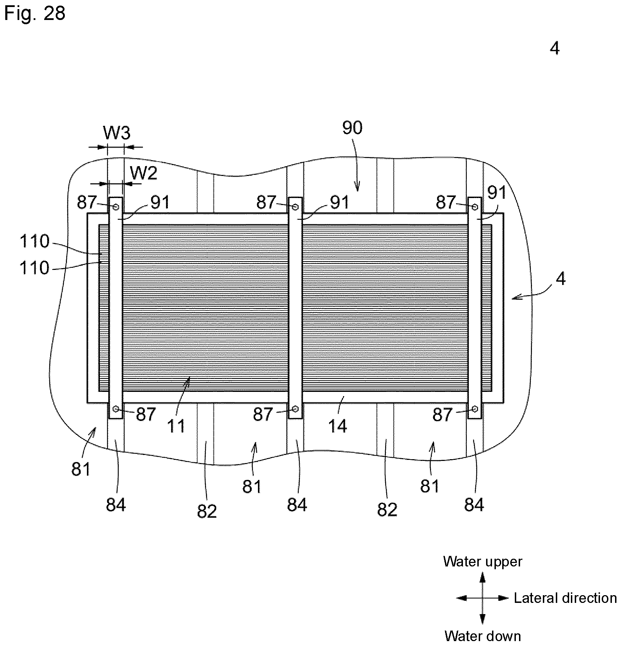

In the above modification, the photovoltaic power generation sheet 4 is disposed in such a manner that the longitudinal direction of the power generation cell 110 is parallel to the water flow direction. As illustrated in Fig. 28, the photovoltaic power generation sheet 4 may be disposed in such a manner that the longitudinal direction of the power generation cell 110 is parallel to the lateral direction. The photovoltaic power generation sheet 4 is disposed in such a manner that the photovoltaic power generation sheet 4 is across the plurality of convex portions 81 in the lateral direction.

The attachment member 91 is fixed to the roof surface in such a manner that the longitudinal direction of the attachment member 91 is parallel to the water flow direction. The attachment member 91 is fixed to the top portion 84 of one convex portion 81 in the extending direction of the convex portion 81. Thus, the photovoltaic power generation sheet 4 contacts the attachment member 91 over the entire length in the water flow direction. As a result, the attachment member 91 can attach the photovoltaic power generation sheet 4 to the roof surface by pressing the end portion in the longitudinal direction of the photovoltaic power generation sheet 4 against the roof surface. The width W2 of the attachment member 91 is preferably equal to or less than the width W3 of the top portion 84 of the convex portion 81.

As described above, when the photovoltaic power generation sheet 4 is disposed in such a manner that the longitudinal direction of the power generation cell 110 is parallel to the lateral direction, the entire power generation cell 110 is not covered with streaky dirt even when streaky dirt occurs on the light receiving surface of the photovoltaic power generation sheet 4 in the water flow direction. As a result, even when streaky dirt is formed on the light receiving surface of the photovoltaic power generation sheet 4 in the water flow direction, it is possible to reduce a decrease in power generation efficiency.

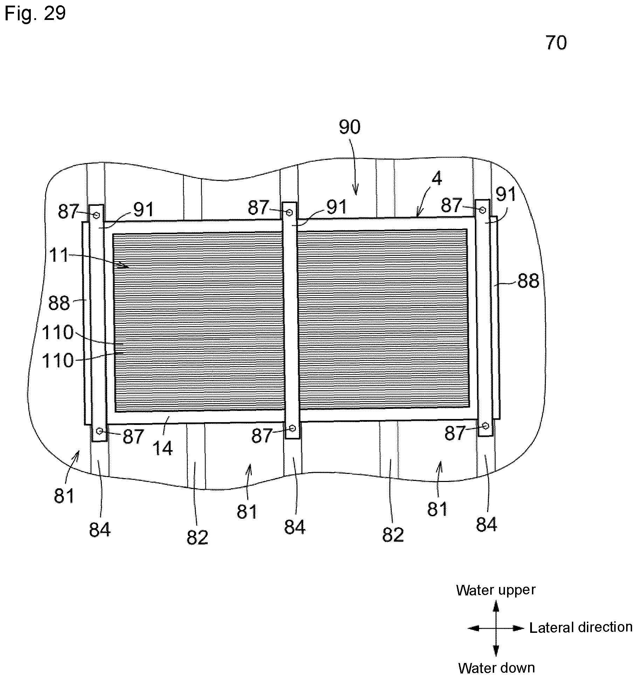

In the above modification, all attachment members 91 overlap the power generator 11, and at least one attachment member 91 may be disposed in such a manner that the attachment member 91 overlaps the power generator 11. For example, as illustrated in Fig. 29, a region 88 in which the power generator 11 is not provided may be provided at both end portions of the photovoltaic power generation sheet 4 in the longitudinal direction, and the region may be fixed by the attachment member 91.

In a case of the photovoltaic power generation sheet 4 having the photoelectric conversion layer 222 containing a perovskite compound, the power generator 11 is not limited to a rectangular shape, and can be easily designed. By taking advantage of this characteristic, the shape of the photovoltaic power generation sheet 4 can be adapted to the shape of the installation surface 2. In the above modification, the photovoltaic power generation sheet 4 has a rectangular shape in plan view, and for example, in a case where the installation surface 2 has a fan shape in plan view, the photovoltaic power generation sheet 4 may also be formed in a fan shape in plan view. In this case, the longitudinal direction of the attachment member 91 may intersect the longitudinal direction of the power generation cell 110. The shape of the photovoltaic power generation sheet 4 is not limited to a fan shape, and examples thereof include a circular shape, an elliptical shape, and a polygonal shape.

The shortest distance between the end portion of the photovoltaic power generation sheet 4 and the power generator 11 is preferably 50 mm or less, more preferably 35 mm or less, and still more preferably 25 mm or less. In this manner, the power generation efficiency can be improved by making the area of the power generator 11 as large as possible. In addition, by setting the shortest distance between the end portion of the photovoltaic power generation sheet 4 and the power generator 11 to 5 mm or more, more preferably 10 mm or more, and still more preferably 15 mm or more, the water resistance when the photovoltaic power generation sheet 4 is used outdoors can be improved.

A rod-shaped core member may be attached to the end portion of the photovoltaic power generation sheet 4. The rod-shaped core member is preferably fixed to the end portion of the photovoltaic power generation sheet 4 in such a manner that the central axis thereof is parallel to the shortitudinal direction of the photovoltaic power generation sheet 4. When the rod-shaped core member is rotated around the central axis, the photovoltaic power generation sheet 4 is wound around the rod-shaped core member. Therefore, the photovoltaic power generation sheet 4 is not a sheet shape but a rod shape at the time of transportation, and the transportability can be improved. Further, by winding the photovoltaic power generation sheet 4 around the rod-shaped core member even after installation, the photovoltaic power generation sheet 4 can be temporarily removed from the installation surface 2 in an easy manner, and reinstallation can be facilitated. As a result, the photovoltaic power generation sheet 4 can be temporarily removed and stored in a bad weather such as a storm. The shape of the rod-shaped core member is not particularly limited as long as the rod-shaped core member can be wound with the photovoltaic power generation sheet 4, and the rod-shaped core member may be either hollow or solid, and the cross-sectional shape may be circular or polygonal. In addition, a handle may be provided on the rod-shaped core member, and the rod-shaped core member may be rotated by the handle. In addition, the power of the motor may be transmitted to the rod-shaped core member, and the rod-shaped core member may be rotated by the motor.

The winding diameter of the rod-shaped core member is preferably 5 cm or more, more preferably 7.5 cm or more, and still more preferably 10 cm or more. On the other hand, the winding diameter of the rod-shaped core member is preferably 30 cm or less, more preferably 20 cm or less, and still more preferably 15 cm or less. By setting the winding diameter of the rod-shaped core member to 5 cm or more, breakage of the photovoltaic power generation sheet 4 can be suppressed. By setting the winding diameter of the rod-shaped core member to 30 cm or less, transportation and construction can be easily performed.

In the modification described above, the back sheet 10 of the photovoltaic power generation sheet 4 is directly fixed to the installation surface 2, and another sheet member may be interposed between the back sheet 10 and the installation surface 2. Examples of the sheet member include a synthetic resin sheet, a fiber-reinforced resin sheet, and an elastic sheet such as rubber. Thus, the photovoltaic power generation sheet 4 can be prevented from being displaced.

The sheet member is detachably attached to the installation surface 2. Thus, the photovoltaic power generation sheet 4 is detachably fixed to the installation surface 2. As a fixing structure between the sheet member and the installation surface 2, at least one selected from the group consisting of a hook-and-loop fastener, a magnet, a double-sided tape, a bonder, a flange member, a sandwiching member, a hanging member, and a frame member described above is used.

In the above modification, substantially all of attachment members 91 overlap the power generator 11. However, as long as the longitudinal direction of the attachment members 91 intersects the longitudinal direction of the power generation cell 110, the present invention also includes attachment members 91 that only partially overlap the power generator 11.

In the above modification, the installation structure 90 in which the photovoltaic power generation sheet 4 is installed on the roof surface has been described, but the installation surface 2 is not limited to the roof surface, and can be applied to, for example, a wall member (metal-based siding material, ceramic-based siding material, sandwich panel, and the like), a partition, a door member, a fence member, and the like.

In the above modification, the photovoltaic power generation sheet 4 having the photoelectric conversion layer 222 containing the perovskite compound has been described as an example, and in the present invention, a photovoltaic power generation sheet 4 can exhibit the same effect, as long as the photovoltaic power generation sheet 4 is flexible. Further, the photovoltaic power generation sheet 4 according to the present invention may be not only a solar cell capable of obtaining a power generation effect by light, but also a sheet (light energy conversion sheet) that converts light energy into another energy. Examples of the light energy conversion sheet include, in addition to the photovoltaic power generation sheet 4, a light heating sheet (photovoltaic power-driven thermoelectric conversion device) that converts light energy into thermal energy.

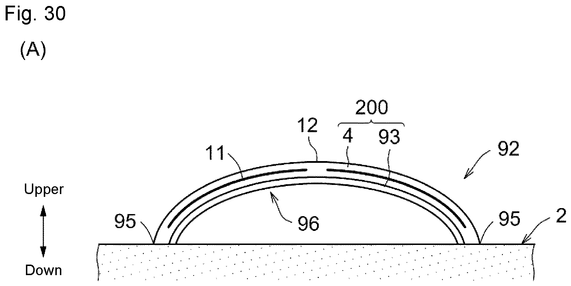

Further, the installation structure for the photovoltaic power generation sheet of the present invention can be modified as illustrated in Fig. 30. An installation structure 92 of the photovoltaic power generation sheet illustrated in Fig. 30 includes an installation surface 2 and a photovoltaic power generation sheet 200 provided on an upper side of the installation surface 2. As illustrated in Fig. 30, the photovoltaic power generation sheet 200 includes a power generation sheet main body 4 and a shape holder 93. The power generation sheet main body 4 has the same structure as the photovoltaic power generation sheet 4 illustrated in Fig. 2, and includes a back sheet 10, a power generator 11, a barrier sheet 12 including a light receiving surface, a sealant 13, and a sealing edge member 14, and a critical surface tension γc of a surface of the power generation sheet main body 4 (surface of the photovoltaic power generation sheet 200) is 20 or more and 45 or less. The power generation sheet main body 4 is flexible, and the shape holder 93 can hold the power generation sheet main body 4 in a deformed state. In the installation structure 92 of the photovoltaic power generation sheet 200, the photovoltaic power generation sheet 200 maintained in a deformed state is installed on the installation surface 2.

In this way, since the angle of the light receiving surface of the photovoltaic power generation sheet 200 can be maintained at a position adjusted to a desired angle, water easily flows over the upper surface of the photovoltaic power generation sheet 200, and dirt such as dust and grime is less likely to accumulate. In addition, it is easy to adjust the angle of the light receiving surface with respect to sunlight to an angle with excellent light emission efficiency. The photovoltaic power generation sheet 200 is disposed in such a manner that the surface of the power generation sheet main body 4 (surface of the photovoltaic power generation sheet 200) includes a surface inclined at an angle of 1.5° or more with respect to the horizontal plane.

### Shape holder 93

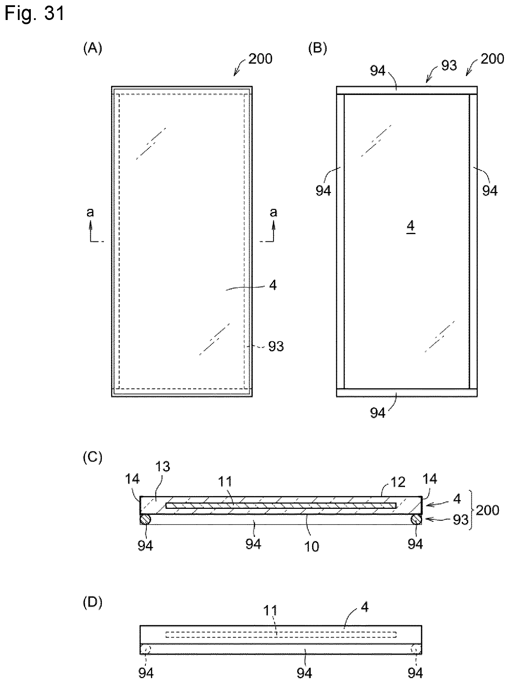

The shape holder 93 can hold the power generator 11 and the barrier sheet 12 in a deformed state. As illustrated in Fig. 31(B), the shape holder 93 according to the present modification includes a plurality of rod bodies 94 attached to the power generation sheet main body 4. The plurality of rod bodies 94 are attached to a back surface (lower surface) of the barrier sheet 12 of the power generation sheet main body 4. In the present modification, the plurality of rod bodies 94 are disposed along the entire circumference of the outer peripheral edge of the power generation sheet main body 4.

The shape holder 93 preferably is flexible. However, the elastic modulus of the shape holder 93 is higher than the elastic modulus of the power generation sheet main body 4. In this way, it is easy to maintain the angle of the light receiving surface of the photovoltaic power generation sheet 200 at the adjusted position under a state where the photovoltaic power generation sheet 200 is installed. In the present modification, each rod body 94 is flexible. One rod body 94 may be one rod body continuous in the longitudinal direction, or may include one rod body 94 in which a plurality of components combined in the axial direction. One rod body 94 continuous in the longitudinal direction is plastically deformed, so that the shape can be held steplessly. The rod body 94 in which the plurality of components are combined in the axial direction can be bent by changing the angle between adjacent components, and the shape can be maintained by maintaining the angle between adjacent components. Examples of the rod body 94 include a wire, a corrugated pipe, and a flexible tube. The rod body 94 may be solid or hollow.

Here, the rod body 94 may not be flexible. In this case, the rod body 94 preferably has an angle variable mechanism. Examples of the angle variable mechanism include a ball joint, a universal joint, and a uniaxial movable joint provided in a part of the rod body 94 in the longitudinal direction. Further, the rod body 94 may not be deformable at the work site, and for example, the rod body may be connected in the axial direction using a joint bent in advance.

The shape holder 93 is preferably positioned on the side opposite to the barrier sheet 12 with respect to the power generator 11 in the thickness direction of the photovoltaic power generation sheet 200. In the present modification, the shape holder 93 is attached to the back surface of the barrier sheet 12. Attachment of the shape holder 93 and the barrier sheet 12 is realized by, for example, bonding, screwing, fitting, welding, welding, riveting, brazing, a snap-fit structure, or the like. In this way, it is possible to reduce a decrease in power generation efficiency in the power generator 11 due to the shadow of the shape holder 93.

### Method for installing photovoltaic power generation sheet 200

As illustrated in Fig. 30, for example, when a worker deforms the photovoltaic power generation sheet 200 configured as described above into a curved state at the work site, the photovoltaic power generation sheet is maintained in the curved state. The photovoltaic power generation sheet 200 is placed on the installation surface 2 while the deformation is maintained, whereby the photovoltaic power generation sheet 200 is installed.

A part of the installed photovoltaic power generation sheet 200 is placed on the installation surface 2. In the present specification, in the photovoltaic power generation sheet 200, a portion attached to the installation surface 2 is referred to as a "first portion 95". The number of the first portions 95 may be one or two or more. In the present modification, both end portions of the photovoltaic power generation sheet 200 in the width direction are the first portions 95. The first portion 95 is preferably fixed to the installation surface 2. Examples of a method for fixing the first portion 95 to the installation surface 2 include a bonder, an adhesive, a double-sided tape, a magnet, a screw, and a bolt. Note that the end portion of the photovoltaic power generation sheet 200 in the length direction may be the first portion 95. The fixation of the photovoltaic power generation sheet 200 to the installation surface 2 may be local fixation or fixation on a surface having a certain width or more. By minimizing the fixed portion, the light receiving area of the photovoltaic power generation sheet 200 can be maximized. On the other hand, by performing fixation on the surface, stress generated in the vicinity of the first portion 95 in the photovoltaic power generation sheet 200 due to wind or the like can be alleviated, and stress can be suppressed from being locally generated.

A portion other than the first portion 95 in the photovoltaic power generation sheet 200 is referred to as a second portion 96. At least a part of the second portion 96 is inclined with respect to the installation surface 2. The entire surface of the second portion 96 may be inclined with respect to the installation surface 2, or only a part of the second portion 96 may be inclined with respect to the installation surface 2. The second portion 96 may be curved in an arch shape or may be curved in a spherical shape. In addition, the second portion 96 may be curved in a corrugated cross-sectional shape such that unevenness is repeated, or may be planar shape.

The inclined portion of the second portion 96 is preferably separated from the installation surface 2. In this way, the worker can easily insert a hand between the second portion 96 and the installation surface 2. As a result, the worker can easily adjust the angle of the photovoltaic power generation sheet 200 with respect to the installation surface 2 even after installing the photovoltaic power generation sheet 200 on the installation surface.

### Effects

As described above, since the photovoltaic power generation sheet 200 according to the present modification includes the shape holder 93, the angle of the light receiving surface of the photovoltaic power generation sheet 200 can be maintained in a state of being adjusted to a desired angle. Therefore, water easily flows over the upper surface of the photovoltaic power generation sheet 200, and dirt such as dust and grime is less likely to accumulate. In addition, it is easy to adjust the angle of the light receiving surface with respect to sunlight to an angle with excellent light emission efficiency.

In addition, since the shape holder 93 is positioned on the side opposite to the barrier sheet 12 with respect to the power generator 11 in the thickness direction of the photovoltaic power generation sheet 200, the deterioration of the power generation efficiency is reduced.

In addition, in the installation structure 92 of the photovoltaic power generation sheet 200 according to the present modification, the first portion 95 of the photovoltaic power generation sheet 200 is attached on the installation surface 2, and at least a part of the other portion is inclined with respect to the installation surface 2. Therefore, water easily flows over the upper surface of the photovoltaic power generation sheet 200, and dirt such as dust and grime is less likely to accumulate.

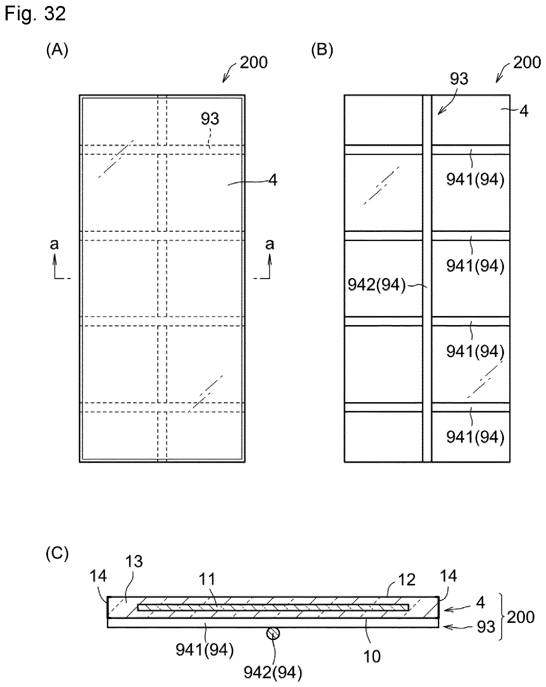

In the above modification, the plurality of rod bodies 94 is disposed along the outer peripheral edge of the back sheet 10. As illustrated in Fig. 32, the plurality of rod bodies 94 may include a first rod body 941 and a second rod body 942 disposed in a portion other than the outer peripheral edge.

The first rod body 941 is disposed parallel to the width direction of the power generation sheet main body 4. A plurality of first rod bodies 941 is disposed at regular intervals in the length direction of the power generation sheet main body 4. The second rod body 942 is disposed at the center of the power generation sheet main body 4 in the width direction. A plurality of second rod bodies 942 may be provided. In a case where the plurality of second rod bodies 942 are provided, the second rod bodies 942 are disposed at intervals in the width direction of the power generation sheet main body 4. As illustrated in Fig. 32(C), the second rod body 942 is fixed to the first rod body 941 on the side opposite to the power generation sheet main body 4. The first rod body 941 and the second rod body 942 are fixed by, for example, welding, bonding, fastening, bolting, or the like.

The first rod body 941 and the second rod body 942 may be applied in addition to the rod body 94 disposed along the outer peripheral edge of the back sheet 10 as in the embodiment.

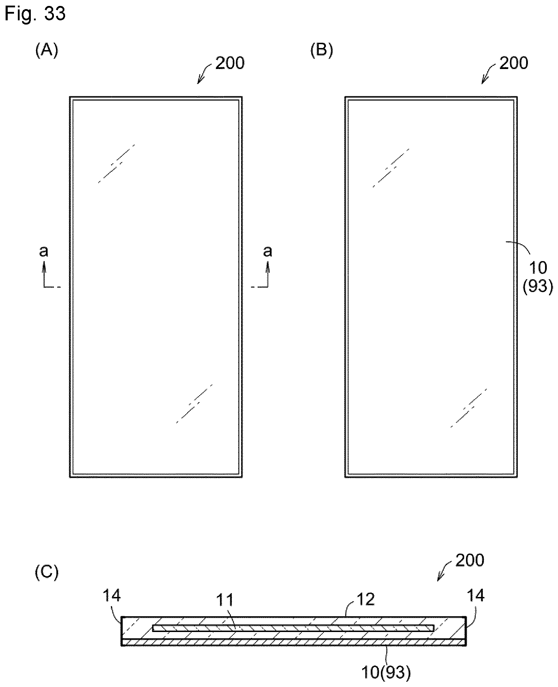

As illustrated in Fig. 33, the shape holder 93 may be a back sheet 10. The back sheet 10 can hold the power generator 11 and the barrier sheet 12 in a deformed state by being plastically deformed. Examples of the back sheet 10 include metal materials such as a metal plate, a knitted wire mesh, and a metal sheet. The barrier sheet 12 may be made of, for example, synthetic resin, carbon, or the like. Since the shape holder 93 covers the entire lower surfaces of the power generator 11 and the barrier sheet 12, it is possible to hold a deformed shape with a higher degree of freedom, such as partially deforming the power generator 11 in a convex shape.

In a case where a metal back sheet 10 is used, the lower surface of the back sheet 10 is preferably covered with a protective layer. Examples of the protective layer include coating with a resin film, a rubber film, or the like.

A shape memory resin or metal may be used for the back sheet 10. At the time of conveyance and construction, since the back sheet 10 is flat, transportability can be improved, and by performing heat treatment on site, the back sheet 10 can be restored to a specific shape, so that construction can be improved.

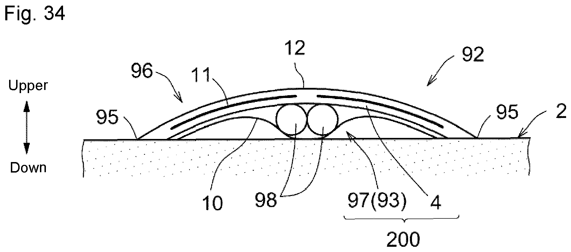

As illustrated in Fig. 34, the shape holder 93 may be a spacer 97 disposed between the installation surface 2 and the power generator 11. The spacer 97 maintains a distance between the installation surface 2 and the back sheet 10 in the second portion 96 of the photovoltaic power generation sheet 200. Since the power generation sheet main body 4 is flexible, when the first portion 95 is attached to the installation surface 2 and the second portion 96 is separated from the installation surface 2, at least a part of the second portion 96 is inclined with respect to the installation surface 2. That is, the spacer 97 can hold the power generator 11 and the barrier sheet 12 in a deformed state by maintaining the distance between the second portion 96 and the installation surface 2.

Examples of the spacer 97 include a rod shape, a block shape, a box shape, and a flat plate shape. The spacer 97 is preferably an electric cable 98 electrically connected to the power generator 11. The electric cable 98 may be or may not be fixed to the lower surface of the back sheet 10, or may be disposed between the back sheet 10 and the power generator 11. In a case where the electric cable 98 is disposed between the back sheet 10 and the power generator 11, a portion of the back sheet 10 corresponding to the electric cable 98 protrudes downward from the other portion. The protruded portion serves as the spacer 97.

The photovoltaic power generation sheet 200 and the spacer 97 may or may not be integrated. In a case where the photovoltaic power generation sheet 200 and the spacer 97 are integrated, handleability such as construction can be improved. In a case where the photovoltaic power generation sheet 200 and the spacer 97 are not integrated, conveyance and construction can be performed for each individual member, so that it is possible to improve manageability and a degree of freedom in construction on site.

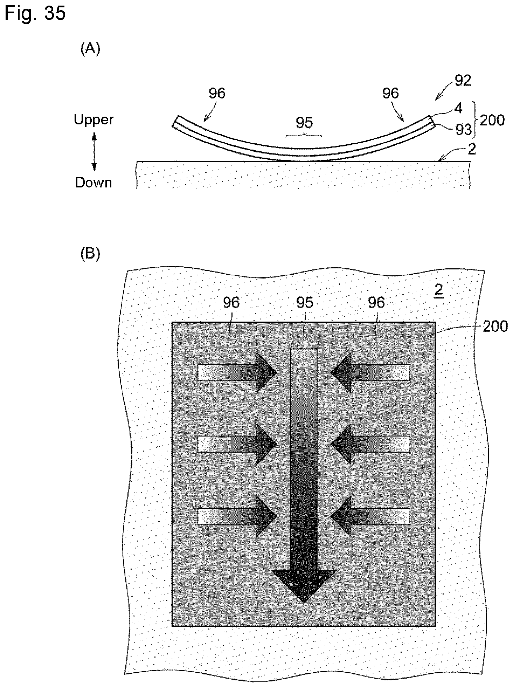

In the above modification, the photovoltaic power generation sheet 200 is curved in such a manner that the central portion in the width direction bulges upward, and the photovoltaic power generation sheet 200 may be curved in such a manner that the central portion in the width direction warps downward as illustrated in Fig. 35. The first portion 95 is a central portion in the width direction of the photovoltaic power generation sheet 200. The second portion 96 is positioned on both sides of the first portion 95 in the width direction of the photovoltaic power generation sheet 200.

The second portion 96 is inclined with respect to the installation surface 2 in such a manner that the second portion 96 is positioned upward from the first portion 95 toward the outside in the width direction. The upper surface of the second portion 96 is inclined downward toward the first portion 95. As illustrated in Fig. 35(B), the upper surface of the first portion 95 preferably has a gradient in a direction in the length direction of the photovoltaic power generation sheet 200. The upper surface of the first portion 95 may be inclined downward from one side to the other side in the longitudinal direction, or may be inclined downward from the central portion in the longitudinal direction toward the end portions on both sides in the longitudinal direction. In this way, the rainwater having dropped on the upper surface of the second portion 96 flows toward the central portion in the width direction (that is, the first portion 95), and when arriving at the first portion 95, the rainwater flows toward one side in the length direction. Therefore, rainwater is reduced from remaining on the upper surface of the photovoltaic power generation sheet 200 in the installed state. In the present modification, the "width direction" may be referred to as a "length direction", and the "length direction" may be referred to as a "width direction".

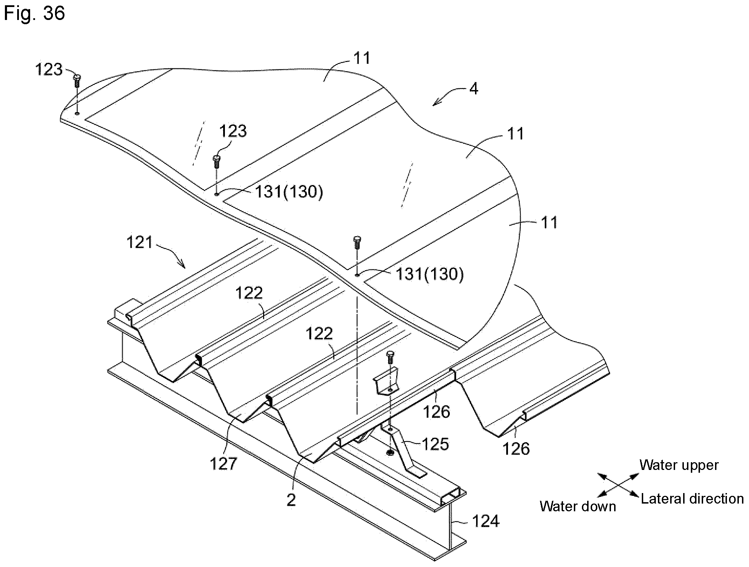

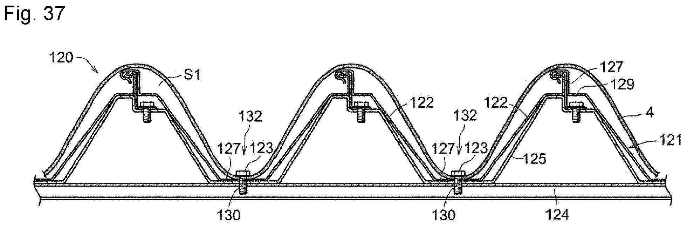

Further, the installation structure for the photovoltaic power generation sheet of the present invention can be modified as illustrated in Figs. 36 and 37. As illustrated in Fig. 36, the installation structure 120 of the photovoltaic power generation sheet illustrated in Figs. 36 and 37 includes an exterior member 121, a photovoltaic power generation sheet 4, and a plurality of fixing members 123, and the photovoltaic power generation sheet 4 is provided on an upper side of an installation surface 2 constituted by the exterior member 121.

In the exterior member 121, a plurality of convex portions 122 extending in one direction are formed at intervals. The photovoltaic power generation sheet 4 is flexible and a flexural strength of 50 MPa or more and 200 MPa or less. The photovoltaic power generation sheet 4 is disposed across a plurality of convex portions 122, and is fixed to a portion between the adjacent convex portions 122 by a fixing member 123 as illustrated in Fig. 37.

As described above, according to the installation structure 120 according to the present modification, the photovoltaic power generation sheet 4 is along the plurality of convex portions 122 in the cross section, and is fixed to a portion between adjacent convex portions 122 by the fixing member 123. Therefore, the surface area of the photovoltaic power generation sheet 4 per unit area of the roof surface can be made as large as possible as compared with a flat plate-shaped solar cell panel having high rigidity.

In order to maintain the shape of the photovoltaic power generation sheet 4 that is flexible, it is necessary to relatively increase the number of the fixing members 123 as compared with the solar cell panel. In general, when the number of the fixing members 123 increases, the shadow of the fixing member 123 overlaps the power generator 11, and there is a concern that the power generation efficiency decreases. However, in the present modification, by disposing the fixing member 123 in the portion between adjacent convex portions 122, it is possible to prevent the protruding portion in the photovoltaic power generation sheet 4 from overlapping the shadow of the fixing member 123.

Hereinafter, each configuration of the installation structure 120 according to the present modification will be described in more detail.

### Exterior member 121

The exterior member 121 is a building material that forms an outer surface of a building. As described above, in the exterior member 121, the plurality of convex portions 122 extending in one direction is formed at intervals in the direction orthogonal to the one direction. Examples of the exterior member 121 include a roof member, a wall material (metal-based siding material, ceramic-based siding material, sandwich panel, and the like), a partition, a door material, and a fence material. In the present modification, a roof member will be described as an example of the exterior member 121.

Examples of the roof member include a uneven roof member (uneven exterior member) used for a folded plate roof, a slate roof, a roof deck, a shingled bar-laid roof, an upright flat laid roof, and the like. The roof may be a vertical roof or a horizontal roof. In the present modification, a folded plate roof as a vertical roof will be described as an example of a roof formed by the exterior member 121.

Here, as illustrated in Fig. 36, the highest portion on one roof surface is defined as "water upper", and the lowest portion is defined as "water down". In addition, a direction parallel to a line segment connecting water upper and water down at the shortest distance is defined as a "water flow direction". In the present modification, the water upper is the ridge, the water down is the eaves, and the water flow direction is parallel to the eaves ridge direction. In addition, a direction orthogonal to the water flow direction and along the roof surface is defined as a "lateral direction".

The building in which the exterior member 121 is used may be a non-residential building or a residential building. Examples of the non-residential building include a store, a warehouse, a factory, a meeting place, a gymnasium, a parking lot, and the like. Examples of the residential building include a wooden house, a steel frame house, a reinforced concrete house, and an aluminum house.

As illustrated in Fig. 36, the exterior member 121 is attached to the cross member 124 via a plurality of tight frames 125. The cross member 124 is a horizontal member in a building, and is bridged between columns, for example. Examples of the cross member 124 include a beam (including girders, joists, and the like.), a beam, a purlin, and the like. The tight frames 125 are fixed to the upper surface of the cross member 124 and support the exterior member 121. The plurality of tight frames 125 are arranged at intervals in the water flow direction.

As illustrated in Fig. 36, the exterior member 121 includes a plurality of fold plate members 126. Each of the fold plate members 126 is formed in a substantially V-shaped cross section. Each of the fold plate members 126 is formed by bending a metal plate. The exterior member 121 is disposed in such a manner that the longitudinal direction of each of the plurality of fold plate members 126 is parallel to the water flow direction, and is configured by joining the end portions of adjacent fold plate members 126 to each other. A method for joining adjacent fold plate members 126 is not particularly limited, and examples thereof include a haze-fastening method, a stacking method, and a fitting method. In the present modification, as illustrated in Fig. 37, a haze-fastening method is adopted. Hereinafter, this haze-fastened portion may be referred to as a "joint portion 128".

As illustrated in Fig. 36, the convex portion 122 of the exterior member 121 extends in the water flow direction. The convex portion 122 according to the present modification is formed by joining end portions of adjacent fold plate members 126 to each other. A plurality of convex portions 122 are formed in the exterior member 121, and a plurality of convex portions 122 are formed at intervals in the lateral direction. A valley portion 127 is formed between adjacent convex portions 122. In short, the exterior member 121 is formed by repeating the convex portion 122 and the valley portion 127 in the lateral direction, and is formed in an uneven cross section.

As illustrated in Fig. 37, each of the convex portions 122 is formed in a shape (an inverted V shape in cross section) in which the width narrows toward a top portion side. The top portion of the convex portion 122 includes a top surface 129 formed in a substantially planar shape and a joint portion 128 protruding upward from the center of the top surface 129 in the lateral direction. The shape of each of the convex portions 122 is not necessarily an inverted V-shaped cross section, and may be, for example, a rectangular cross section, a C-shaped cross section, or the like.

In the present modification, each of the valley portions 127 is formed in a substantially planar shape. Here, in the present invention, the valley portion 127 does not need to be a flat surface. For example, in a case where the exterior member 121 is a corrugated slate, the exterior member is formed in a curved surface shape projecting downward. In this case, the boundary between the convex portion 122 and the valley portion 127 does not appear, but a surface passing through the midpoint of the line segment connecting the upper end of the convex portion 122 and the lower end of the valley portion 127 and parallel to the water flow direction is defined as the boundary surface between the convex portion 122 and the valley portion 127.

The height of the convex portion 122 in the cross section of the exterior member 121 is, for example, 1.5 times or more, more specifically, 2 times or more the width of the valley portion 127 in the lateral direction. The upper limit of the height of the convex portion 122 is, for example, 5 times or less the width of the valley portion 127. However, the height of the convex portion 122 is not particularly limited since the height of the convex portion 122 is appropriately set according to the type of the exterior member 121. The "height of the convex portion 122" as used herein refers to a length from the upper surface (upper end) of the valley portion 127 to the upper end of the joint portion 128 in the end surface orthogonal to the water flow direction of the exterior member 121.

### Installation structure 120

As illustrated in Fig. 37, the photovoltaic power generation sheet 4 having such a configuration is attached to the exterior member 121. The photovoltaic power generation sheet 4 is disposed across the plurality of convex portions 122 and is fixed to the valley portion 127 by a fixing member 123. At this time, the photovoltaic power generation sheet 4 is not fixed to the plurality of convex portions 122. Since the photovoltaic power generation sheet 4 is flexible, when the photovoltaic power generation sheet 4 is disposed across the plurality of convex portions 122 and fixed to the valley portion 127, the fixed portion, of the photovoltaic power generation sheet 4 along the convex portions 122 in the cross section, is positioned closer to the base side of the convex portions 122 than the top surfaces 129 of the convex portions 122. Note that the photovoltaic power generation sheet 4 is disposed in such a manner that the surface of the photovoltaic power generation sheet 4 includes a surface inclined at an angle of 1.5° or more with respect to the horizontal plane. Hereinafter, in the photovoltaic power generation sheet 4, a portion fixed by the fixing member 123 may be referred to as an "attachment portion 130".

The fixing member 123 fixes the photovoltaic power generation sheet 4 to the valley portion 127. The fixing member 123 is not particularly limited as long as the photovoltaic power generation sheet 4 can be fixed to the valley portion 127, and examples thereof include a bolt, a screw, a clip sandwiching the photovoltaic power generation sheet 4, a bonder, a magnet, a pin, a nail, and a weight. As the fixing member 123, a bonder, a magnet, or a weight, which is the fixing member 123 that does not require a hole in the exterior member 121, is preferably used from the viewpoint of the waterproof property of the exterior member 121. In addition, it is preferable to use a bolt and a screw from the viewpoint of construction and attachment strength. In the present modification, a bolt will be described as an example of the fixing member 123.

The fixing member 123 is attached to the valley portion 127. The fixing member 123 is preferably attached to a position (this may be referred to as a "position corresponding to the tight frame 125") overlapping the tight frame 125 in the exterior member 121. As a result, the attachment strength of the fixing member 123 to the exterior member 121 can be improved. As a result, for example, the negative pressure strength of the photovoltaic power generation sheet 4 can be increased, and peeling of the photovoltaic power generation sheet 4 from the exterior member 121 can be suppressed.

As illustrated in Fig. 36, the attachment portion 130 of the photovoltaic power generation sheet 4 is a through hole 131 in the present modification. A plurality of through holes 131 are formed at regular intervals along a portion between adjacent power generators 11. The plurality of through holes 131 are arranged at regular intervals in the lateral direction. That is, in the present modification, since the attachment portion 130 is formed in a portion other than the power generator 11, a portion protruding from the surface of the photovoltaic power generation sheet 4 in the fixing member 123 (here, the head of the bolt) can be positioned in a portion other than the power generator 11.

Therefore, in the present modification, not only the power generator 11 can be positioned at the position corresponding to the convex portion 122, but also the shadow generated by the fixing member 123 can be prevented from overlapping the power generator 11 as much as possible. As a result, it is possible to arrange the power generator 11 at a position easily exposed to sunlight while reducing a decrease in power generation efficiency due to the shadow generated by the fixing member 123, and to obtain high power generation efficiency.

The pitch of the plurality of through holes 131 formed along the portion between the adjacent power generators 11 is, for example, 50 mm or more and 200 mm or less, and more specifically, 100 mm or more and 150 mm or less.

When the fixing member 123 is a bonder, the attachment portion 130 does not need to be the through hole 131, and thus the power generator 11 may be positioned at a position corresponding to the valley portion 127. In this case, for example, one power generator 11 may be disposed across two adjacent convex portions 122. In this case, one region (glue margin) to which the bonder is applied is the attachment portion 130 of the photovoltaic power generation sheet 4.

In a case where the fixing member 123 is a magnet, for example, the photovoltaic power generation sheet 4 may be sandwiched between the magnet and the exterior member 121. In this case, the magnet is disposed in a portion between adjacent power generators 11. In this aspect, a portion where the magnet is placed among the portions between adjacent power generators 11 is the attachment portion 130 of the photovoltaic power generation sheet 4. In a case where the fixing member 123 is a magnet, it is preferable that the tight frame 125 or the exterior member 121 is made of a magnetic material.

Further, it is preferable that the end portion in the lateral direction of the photovoltaic power generation sheet 4 are not positioned on the valley portions 127. That is, it is preferable that the attachment portion 130 is not provided at the end portion in the lateral direction of the photovoltaic power generation sheet 4, in other words, it is preferable that the attachment portion 130 is positioned at the intermediate portion in the lateral direction of the photovoltaic power generation sheet 4. In the present modification, the term "end portion in the lateral direction of the photovoltaic power generation sheet 4" refers to a position corresponding to the sealing edge member 14, and the term "intermediate portion in the lateral direction of the photovoltaic power generation sheet 4" refers to a portion between the sealing edge members 14 (portion covered with the barrier sheet 12) in the lateral direction.

When it rains, rainwater collects in a portion above the valley portion 127 which is the lowest position on the upper surface of the photovoltaic power generation sheet 4. This portion is referred to as a "drain portion 132". The drain portion 132 extends in the water flow direction and is inclined downward to the water down side. The rainwater collected in the drain portion 132 flows in the water flow direction, and flows from the end portion on the water down side of the photovoltaic power generation sheet 4 onto the valley portion 127.

Since the drain portion 132 is formed of the intermediate portion in the lateral direction of the photovoltaic power generation sheet 4, that is, a part of the upper surface of the barrier sheet 12, the portion of the sealing edge member 14 where water is relatively likely to be immersed can be kept away from the drain portion 132. Therefore, it is possible to suppress water from entering the power generator 11 of the photovoltaic power generation sheet 4.

Here, the fixing member 123 passed through the through hole 131 is provided with a water-blocking member (for example, sealing member, caulking member, gasket, and the like). Therefore, in the present modification, even when the through hole 131 is provided in the drain portion 132, water immersion from the through hole 131 is suppressed. Even when the water-blocking member is broken and water enters from the through hole 131, not only the through hole 131 is formed in a portion corresponding to the sealant 13, but also the through hole 131 and the power generator 11 are separated from each other by a predetermined distance or more, so that water entering the power generator 11 is suppressed.

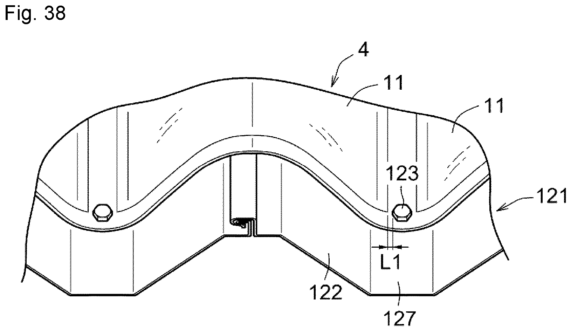

Here, Fig. 38 is a perspective view of the end portions on the water down side of the exterior member 121 and the photovoltaic power generation sheet 4 as viewed from above. In the present modification, a minimum distance L1 between the fixing member 123 and the power generator 11 positioned closest to the fixing member 123 is designed to be 5 mm or more, preferably 15 mm or more. Since the distance L1 is designed to be 15 mm or more, the distance between the through hole 131 and the power generator 11 can be maintained at a predetermined distance or more. As a result, even when water enters the through hole 131 serving as the attachment portion 130, water entering the power generator 11 is suppressed. The upper limit value of the distance L1 is not particularly limited, and is, for example, 50 mm or less.

As illustrated in Fig. 37, the maximum value of the gap S1 between the photovoltaic power generation sheet 4 and the outer surface of the exterior member 121 in the cross section orthogonal to the water flow direction is preferably 20 mm or less, and more preferably 15 mm or less. In the present modification, the gap S1 is set to be equal to or smaller than the protruding dimension of the joint portion 128. When the maximum value of the gap S1 is 15 mm or less, it is possible to suppress the wind flowing along the surface of the exterior member 121 from being blown between the photovoltaic power generation sheet 4 and the outer surface of the exterior member 121, and it is possible to suppress flutter of the photovoltaic power generation sheet 4. Note that the photovoltaic power generation sheet 4 and the outer surface of the exterior member 121 may be as close as possible, and the lower limit value of the maximum value of the gap between the photovoltaic power generation sheet 4 and the outer surface of the exterior member 121 may be 0 mm or more.

### Construction method

Next, an example of a construction method for attaching the photovoltaic power generation sheet 4 according to the present modification to the exterior member 121 will be described.

First, the worker places the photovoltaic power generation sheet 4 on the exterior member 121 of the building. The exterior member 121 of the building may be an existing exterior member 121 or an exterior member 121 before being attached to the framework.

The worker flexes the photovoltaic power generation sheet 4 placed on the exterior member 121, and bends the photovoltaic power generation sheet 4 along the convex portion 122. Then, the worker inserts a bolt serving as the fixing member 123 into the through hole 131 of the photovoltaic power generation sheet 4 from above, and screws the bolt into the valley portion 127. A female screw may be formed in advance in the valley portion 127, or a nut may be welded.

Thereafter, the worker performs water-blocking treatment on the bolt and the through hole 131 using a water-blocking member. This completes the construction of the photovoltaic power generation sheet 4. As described above, in the present modification, since the photovoltaic power generation sheet 4 is flexible, even when the worker drops the photovoltaic power generation sheet 4 on the exterior member 121 at the time of construction, the damage of the exterior member 121 can be suppressed. This allows the worker to improve workability.

### Operation and effect

As described above, the installation structure 120 of the photovoltaic power generation sheet 4 according to the present modification includes the photovoltaic power generation sheet 4 having a flexural strength of 50 MPa or more and 200 MPa or less, and the fixing member 123 that fixes the photovoltaic power generation sheet 4 to a portion between adjacent convex portions 122, so that the surface area of the photovoltaic power generation sheet 4 per unit area of the roof surface can be made as large as possible as compared with a flat solar cell panel having high rigidity.

In addition, since the portion of the photovoltaic power generation sheet 4 fixed to the fixing member 123 is positioned closer to the base side of the convex portion 122 than the top surface 129 of the convex portion 122, the portion of the power generator 11 in the photovoltaic power generation sheet 4 can be arranged in such a manner of protruding along the convex portion 122 that is likely to be exposed to sunlight.

Further, since the photovoltaic power generation sheet 4 is not fixed to the plurality of convex portions 122, it is possible to prevent a portion on the convex portions 122 which are likely to be exposed to sunlight from overlapping the shadow of the fixing member 123.

Further, the photovoltaic power generation sheet 4 includes a plurality of power generators 11 containing a perovskite compound. Incidentally, it is known that the photovoltaic power generation sheet 4 having the power generator 11 containing the perovskite compound has small dependence on the incident angle. When the photovoltaic power generation sheet 4 is attached to the exterior member 121 having a plurality of convex portions 122, the angle of the surface of the photovoltaic power generation sheet 4 with respect to the sunlight continuously changes, but by using the photovoltaic power generation sheet 4 containing the perovskite compound, it is possible to suppress the deterioration of the power generation efficiency.

Further, since the fixing member 123 is attached to the portion other than the power generator 11 in the photovoltaic power generation sheet 4, it is possible to suppress the influence of the fixing member 123 on the power generation efficiency.

In the photovoltaic power generation sheet 4, the intermediate portion of the barrier sheet 12 is fixed by the fixing member 123, and the intermediate portion constitutes the drain portion 132, so that water is less likely to enter the power generator 11.

The present disclosure includes the following items.

As one aspect of a conventional photovoltaic power generation module, there is a building material-integrated solar cell module in which a photovoltaic element is disposed between a back surface member and a front surface member.

The photovoltaic element is configured by sandwiching a semiconductor photoactive layer between a conductive flexible substrate and a transparent electrode layer. The semiconductor photoactive layer is configured by arranging a plurality of power generation cells extending in one direction in the width direction.

In the conventional photovoltaic power generation module, when the photovoltaic power generation module is attached to a building, the longitudinal direction of the power generation cell may be parallel to the direction in which water flows (water flow direction) on the surface.

In this case, when streaky dirt occurs on the surface of the photovoltaic power generation module, any one of the plurality of power generation cells arranged in the width direction is covered over the entire length in the longitudinal direction by the streaky dirt. There is a problem in this type of photovoltaic power generation sheet that, even when only one of the plurality of power generation cells is covered over the entire length in the longitudinal direction, the power generation efficiency is extremely decreased.

Furthermore, with the progress of technology in recent years, an increase in size of a photovoltaic power generation sheet has been studied because the photovoltaic power generation sheet is lightweight. Compared with a conventional rigid solar cell, a photovoltaic power generation sheet that is soft and flexible is likely to receive an external force due to wind or the like, and therefore it is necessary to further increase the number of fixing members. However, since the above-described streaky dirt is likely to accumulate near the fixing member and in the water flow direction, the power generation efficiency is more likely to decrease in the installation structure for the flexible photovoltaic power generation sheet.

In view of the above matters, another object of the present invention is to provide an installation structure for a photovoltaic power generation sheet that can be installed on an installation surface in a state where a decrease in power generation efficiency is suppressed under an installed state.

In order to achieve the above object, the present invention encompasses the subject matter according to the following items.

Item 1. An installation structure for a photovoltaic power generation sheet in which a photovoltaic power generation sheet is attached to an installation surface intersecting a horizontal plane, wherein
the photovoltaic power generation sheet includes a power generator in which a plurality of belt-shaped power generation cells extending in one direction are arranged in a width direction, and
the photovoltaic power generation sheet is disposed with respect to the installation surface in such a manner that a longitudinal direction of each of the plurality of power generation cells intersects a water flow direction of the installation surface.

Item 2. The installation structure according to item 1, wherein
the installation surface is a roof surface of a uneven roof having a gradient,
the uneven roof is configured in such a manner that convex portions and concave portions extending in a water flow direction are alternately arranged in a lateral direction intersecting the water flow direction, and
a longitudinal direction of each of the power generation cells intersects a longitudinal direction of the convex portions and the concave portions.

Item 3. The installation structure according to item 1 or 2, wherein the power generator has a monolithic structure in which the plurality of power generation cells are monolithic.

Item 4. The installation structure according to any one of items 1 to 3, wherein a width of each of the power generation cells is 1 mm or more and 10 mm or less.

Item 5. The installation structure according to any one of items 1 to 4, wherein an angle formed by a light receiving surface of the photovoltaic power generation sheet and a horizontal plane is 15° or more.

The installation structure according to the above aspects of the present invention has an advantage that the photovoltaic power generation sheet can be installed on the installation surface in a state where a decrease in power generation efficiency is suppressed under the installed state.

As a conventional solar panel installation structure, there is an installation structure including a reinforcing member and a fixing member fixed to a surface of a roof with a bonder or the like. One end portion of the solar panel is rotatably attached to a fixing member via a hinge, and the other end portion of the solar panel is detachably fixed to a reinforcing member formed of a magnetic material via a magnet. Thereby, the solar panel is installed on the roof.

A conventional solar panel is a rigid solar cell processed into a plate shape, and is generally installed on a roof using an attachment frame such as a fixing member or a reinforcing member. However, the attachment frame has a complicated structure and is heavy. For this reason, when the solar panel is installed, the work of attaching the attachment frame requires a great effort.

In recent years, photovoltaic power generation sheets using organic solar cells such as perovskite compounds have been widely used. The power generator of this type of photovoltaic power generation sheet has a plurality of belt-shaped power generation cells arranged in the width direction, and is monolithic.

Since the photovoltaic power generation sheet is flexible, when there is a gap between the photovoltaic power generation sheet and the installation surface or when the photovoltaic power generation sheet is only partially fixed, flutter is likely to occur due to the influence of wind or the like under the installed state. In particular, since the photovoltaic power generation sheet being flexible is lightweight, many of the photovoltaic power generation sheets are increased in size, and it has become clear in recent years that the above problems are more remarkable. Since the photovoltaic power generation sheet has a feature that the power generation efficiency is decreased by vibration, flutter needs to be suppressed as much as possible.

Here, as a method of directly installing the photovoltaic power generation sheet on the surface of the roof, it is conceivable that the entire region of the photovoltaic power generation sheet is fixed to the surface of the roof, or the peripheral edge portion of the photovoltaic power generation sheet is fixed to the surface of the roof over the entire circumference. However, in this method, in a case where the photovoltaic power generation sheet needs to be collected, the power generator of the photovoltaic power generation sheet being flexible is likely to be bent when the photovoltaic power generation sheet is removed from the surface of the roof. In this case, stress may concentrate on the power generator, and the power generator may be broken. Furthermore, in a case of fixing a large-sized photovoltaic power generation sheet, it is necessary to more firmly fix the photovoltaic power generation sheet as compared with a case of fixing a solar cell of a conventional size, and thus breakage is more likely to occur when the photovoltaic power generation sheet is collected.

On the other hand, it is also conceivable to cover the entire outer periphery of the photovoltaic power generation sheet with a frame-shaped frame member. However, when the entire outer periphery of the photovoltaic power generation sheet is covered with the frame-shaped frame member, the power generation cells at both ends of the plurality of power generation cells arranged in the width direction are covered over the entire length in the longitudinal direction. There is a problem in this type of photovoltaic power generation sheet that, even when only one of the plurality of power generation cells is covered over the entire length in the longitudinal direction, the power generation efficiency is extremely decreased. Further, there is a problem that, since only the outer periphery of the photovoltaic power generation sheet is fixed, a sufficient fixing force cannot be obtained.

In view of the above matters, another object of the present invention is to provide an installation structure for a photovoltaic power generation sheet that can be installed on an installation surface in a state where a decrease in power generation efficiency is suppressed under an installed state.

In order to achieve the above object, the present invention encompasses the subject matter according to the following items.

Item 1. An installation structure for a photovoltaic power generation sheet including:
a photovoltaic power generation sheet including a power generator in which a plurality of power generation cells belt-shaped extending in one direction are arranged in a width direction; and
an attachment member that is long and attaches the photovoltaic power generation sheet to an installation surface by pressing the photovoltaic power generation sheet from above, wherein
the attachment member overlaps the power generator, and a longitudinal direction of the attachment member intersects a longitudinal direction of the power generation cells.

The installation structure according to item 1 preferably includes an aspect according to the following item 2.

Item 2. The installation structure according to item 1, wherein
the installation surface is a roof surface having a gradient, and
the photovoltaic power generation sheet is disposed in such a manner that a longitudinal direction of the power generation cells intersects a water flow direction of the roof surface.

The installation structure according to item 2 preferably includes an aspect according to the following item 3.

Item 3. The installation structure according to item 2, wherein
the roof surface is included in a uneven roof configured in such a manner that convex portions and concave portions extending in a water flow direction are alternately arranged in a lateral direction intersecting the water flow direction,
the photovoltaic power generation sheet is disposed in such a manner that a longitudinal direction of the power generation cells is in the lateral direction, and
the attachment member is disposed in such a manner that a longitudinal direction of the attachment member is along at least one of the convex portions, and the attachment member is attached to a top portion of the one convex portion.

The installation structure according to item 1 preferably includes an aspect according to the following item 4.

Item 4. The installation structure according to item 1, wherein
the installation surface is a roof surface having a gradient, and
the photovoltaic power generation sheet is disposed in such a manner that a longitudinal direction of the power generation cells is in a water flow direction of the roof surface.

The installation structure according to item 4 preferably includes an aspect according to the following item 5.

Item 5. The installation structure according to item 4, wherein
the installation surface is a roof surface of a uneven roof having a gradient,
the uneven roof is configured in such a manner that convex portions and concave portions extending in a water flow direction are alternately arranged in a lateral direction intersecting the water flow direction, and
the attachment member is disposed in such a manner that a longitudinal direction of the attachment member is in the lateral direction, and is attached to the convex portions in such a manner of being across the convex portions.

The installation structure according to any one of items 1 to 5 preferably includes an aspect according to the following item 6.

Item 6. The installation structure according to any one of items 1 to 5, wherein a longitudinal direction of the power generation cell is parallel to a longitudinal direction of the photovoltaic power generation sheet.

The installation structure according to the above aspects of the present invention has an advantage that the photovoltaic power generation sheet can be installed on the installation surface in a state where a decrease in power generation efficiency is suppressed under the installed state.

Conventionally, when a flexible photovoltaic power generation sheet is installed on a roof, the photovoltaic power generation sheet is installed on one surface of the roof by a support member.

In the conventional installation structure for the photovoltaic power generation sheet, the photovoltaic power generation sheet is merely placed and installed on one surface of the roof. For this reason, the gradient of the photovoltaic power generation sheet in the installed state depends on the gradient of the installation surface such as the roof gradient. Therefore, there may a case where, when the gradient of the installation surface is small, dirt such as dust or grime is likely to accumulate on the photovoltaic power generation sheet, and an appropriate angle of the light receiving surface with respect to sunlight may not be obtained depending on the gradient of the installation surface.

In view of the above matters, another object of the present invention is to provide a photovoltaic power generation sheet that can adjust the angle of the light receiving surface of the photovoltaic power generation sheet regardless of the angle of the installation surface, and provide an installation structure for the photovoltaic power generation sheet including the photovoltaic power generation sheet.

In order to achieve the above object, the present invention encompasses the subject matter according to the following items.

Item 1. A photovoltaic power generation sheet including:
a power generation unit being flexible;
a barrier sheet covering the power generation unit and being flexible; and
a shape holder that holds the power generator and the barrier sheet in a deformed state.

The photovoltaic power generation sheet according to item 1 preferably includes the aspect according to the following item 2.

Item 2. The photovoltaic power generation sheet according to item 1, wherein the shape holder is positioned closer to a side opposite to the barrier sheet than the power generator in a thickness direction of the photovoltaic power generation sheet.

The photovoltaic power generation sheet according to item 1 or 2 preferably includes the aspect according to the following item 3.

Item 3. The photovoltaic power generation sheet according to item 1 or 2, wherein the shape holder is plastically deformed to hold the power generator and the barrier sheet in a deformed state.

The photovoltaic power generation sheet according to any one of items 1 to 3 preferably includes the aspect according to the following item 4.

Item 4. The photovoltaic power generation sheet according to any one of items 1 to 3, wherein the shape holder is a back sheet disposed on a side opposite to a light receiving side of the power generator.

The photovoltaic power generation sheet according to item 4 preferably includes the aspect according to the following item 5.

Item 5. The photovoltaic power generation sheet according to item 4, the back sheet includes a metal material plastically deformable.

The photovoltaic power generation sheet according to any one of items 1 to 5 preferably includes the aspect according to the following item 6.

Item 6. The photovoltaic power generation sheet according to any one of items 1 to 5, wherein the shape holder is a spacer partially disposed between the installation surface of the photovoltaic power generation sheet and the power generator.

The photovoltaic power generation sheet according to any one of item 6 preferably includes the aspect according to the following item 7.

Item 7. The photovoltaic power generation sheet according to item 6, wherein the spacer is an electric cable electrically connected to the power generator.

Item 8. An installation structure for a photovoltaic power generation sheet including:
the photovoltaic power generation sheet according to any one of items 1 to 7; and
an installation surface on which the photovoltaic power generation sheet is installed, wherein
a first portion that is a portion of the photovoltaic power generation sheet is attached to the installation surface, and at least a part of a second portion that is the other portion is inclined with respect to the installation surface.

The installation structure according to any one of item 8 preferably includes an aspect according to the following item 9.

Item 9. The installation structure according to item 8, wherein a drain hole penetrating in a thickness direction is provided in a lowest portion of the photovoltaic power generation sheet.

The installation structure according to item 9 preferably includes an aspect according to the following item 10.

Item 10. The installation structure according to item 9, wherein the drain hole is formed in the first portion.

According to the photovoltaic power generation sheet and the installation structure according to the above aspects of the present invention, there is an advantage that the angle of the light receiving surface of the photovoltaic power generation sheet can be adjusted regardless of the angle of the installation surface.

### Description of Reference Numerals

1, 30, 40, 42, 43, 44, 50, 65, 66, 67, 90, 92, 120 Installation structure
2 Installation surface
3 Support member
4, 200 Photovoltaic power generation sheet
5 Surface of support member
6 Surface of photovoltaic power generation sheet
31 Groove
110 Power generation cell

## Claims

1. An installation structure for a photovoltaic power generation sheet comprising:
an installation surface; and
a photovoltaic power generation sheet provided on an upper side of the installation surface,
a surface of the photovoltaic power generation sheet including a surface inclined at an angle of 1.5° or more with respect to a horizontal plane, and a critical surface tension γc of a surface of the photovoltaic power generation sheet being 20 or more and 45 or less inclusive.

2. The installation structure according to claim 1, wherein
a groove is formed on a surface of the photovoltaic power generation sheet, and
the groove extends in a direction where a surface of the photovoltaic power generation sheet is inclined.

3. The installation structure according to claim 1, wherein the photovoltaic power generation sheet includes a plurality of power generation cells containing a perovskite compound.

4. The installation structure according to claim 1, wherein in a cross section of the photovoltaic power generation sheet perpendicular to a direction where a surface of the photovoltaic power generation sheet is inclined, a surface of the photovoltaic power generation sheet has an arc shape recessed downward.

5. The installation structure according to claim 1, further comprising
a support member installed on the installation surface, wherein
the support member has a surface inclined at an angle of 1.5° or more with respect to a horizontal plane, and the photovoltaic power generation sheet is installed on a surface of the support member.

6. The installation structure according to claim 1, wherein
the installation surface is inclined at an angle of 1.5° or more with respect to a horizontal plane, and
the photovoltaic power generation sheet is installed on the installation surface.
